# EUROPEAN PATENT APPLICATION

(11) **EP 4 580 328 A1**
(43) Date of publication of application: **02.07.2025**
(21) Application number: 24223642.0
(22) Date of filing: 30.12.2024
(51) Int. Cl.: H05K 7/20

(54) **SYSTEM AND METHOD FOR STANDALONE COOLING UNITS**

(30) Priority: 29.12.2023 US 202363616301 P
(71) Applicant: Hoffman Enclosures, Inc., Anoka, MN 55303 (US)
(72) Inventor: Hillyer, Christopher, Idaho (US); Triebenbach, Jeff, Chisago (US); Smith, Eli, Ramsey (US); Metzger, Darin, Anoka (US); Surdykowski, Paul, Anoka (US)
(74) Representative: Barker Brettell LLP

(57) **Abstract**

A standalone cooling assembly (1600) includes a two-post rack (1704) with a pair of vertical posts (1724) and a planar base (1720). The pair of vertical posts are spaced apart in a lateral direction and at least partially define an air-flow opening between them. The planar base includes a plurality of mounting slots (1750), each of the plurality of mounting slots configured to receive a fastener to mount the two-post rack to a floor. A cooling unit (100) includes a heat exchanger (1200) and at least one fan assembly (114), and is mounted to the two-post rack. The fan assembly is configured to induce a flow of air in a depth direction across the heat exchanger and through the air-flow opening, wherein the depth direction is transverse to the lateral direction.

## Description

### CROSS-REFERENCE TO RELATED APPLICATIONS

This application claims priority to U.S. Provisional Patent Application No. 63/616,301, filed Dec. 29, 2023, the entirely of which is incorporated herein by reference.

### BACKGROUND

Cooling systems can be provided for electrical components in data centers. In some cases, equipment in a data center can be cooled through various means, including through liquid-based cooling systems, air-based cooling systems, or combinations thereof. Electrical equipment within a data center can be housed in racks and can include piping and manifolds for receiving a liquid coolant pumped through a liquid cooling circuit. The liquid coolant can be delivered to components of electrical equipment to provide a heat transfer from those components to the heat of the liquid coolant.

### SUMMARY

Embodiments of the disclosure can provide standalone cooling assemblies including a two-post rack and a cooling unit. The two-post rack can include a pair of vertical posts and a planar base. The pair of vertical posts can be spaced apart in a lateral direction and can at least partially define an air-flow opening between them. The planar base can include a plurality of mounting slots configured to receive a fastener to mount the two-post rack to a floor. The cooling unit can include a heat exchange and at least one fan assembly. The fan assembly can be configured to induce a flow of air in a depth direction across the heat exchanger and through the air-flow opening. The depth direction can be transverse the lateral direction.

In some examples, a maximum width of the assembly in the lateral direction is less than or equal to 600 mm. In some examples, a maximum depth of the assembly in the depth direction is less than 370 mm. In some examples, the planar base includes a first planar section and a second planar section, wherein the first planar section is positioned at a first side of the pair of vertical posts, and the second planar section is positioned on a second side of the pair of vertical posts, the second side opposite the first side in the depth direction. In some examples, the first planar section defines a first length in the depth direction, and the second planar section defines a second length in the depth direction, the first length being greater than the second length. In some examples, the standalone cooling assembly is fixed to a floor of a data center, wherein a rack of electrical equipment is positioned at the second side of the pair of vertical posts. In some examples, the at least one fan assembly includes an axial fan. In some examples, the standalone cooling assembly further includes a gasket installed at a periphery of the air-flow opening, the gasket configured to at least partially seal an interface between the standalone cooling assembly and a rack of electrical equipment. In some examples, each of the pair of vertical posts includes a mounting surface, the mounting surface defining a plane that is transverse to the depth direction, wherein a plurality of mounting apertures are defined in the mounting surface. In some examples, the plurality of mounting apertures includes a keyhole aperture defining a circular portion and a slot portion, wherein a diameter of the circular portion is greater than a width of the slot portion.

Some embodiments of the disclosure can provide a method of cooling electrical equipment within a data center. The method can include providing a two-post rack including a pair of vertical posts and a planar base, the pair of vertical posts spaced apart in a lateral direction and at least partially defining an air-flow opening between them, and the planar base including a plurality of mounting slots. The two-post rack can be mounted to a floor of a data center, wherein mounting the two-post rack includes inserting at least one fastener into one of the plurality of mounting slots. A cooling unit including a heat exchanger and a fan assembly can be provided. The cooling unit can be mounted onto the two-post rack. When the cooling unit is mounted on the two-post rack, the fan assembly can be positioned to induce a flow of air along a depth direction transverse the lateral direction across the heat exchanger and through the air-flow opening.

In some examples, the cooling unit further includes downwardly-extending adjustable feet, and the method further includes extending the downwardly-extending adjustable feet until the feet contact a surface of the planar base. In some examples, the planar base includes an aperture sized to receive a hosing, and the method further includes inserting hosing upwardly through the aperture and fluidly connecting the hosing to the heat exchanger. In some cases, the method further includes installing a gasket on a surface of the two-post rack, along a periphery of the air-flow opening. In some examples, the two-post rack includes a mounting surface defining a keyhole aperture, the keyhole aperture including a circular portion having a first diameter and a slotted portion having a first width, wherein the first diameter is greater than the first width, wherein the cooling unit includes a frame with a protrusion having a shaft and a distal head, wherein mounting the cooling unit includes: positioning the frame with the protrusion axially aligned with the circular portion; inserting the head of the protrusion through the circular portion; and translating the frame so that the shaft is received into the slotted portion.

Some examples of the disclosure provide a standalone cooling assembly including a two-post rack and a cooling unit. The two-post rack can include a pair of vertical posts, a first base plate defining a first planar surface area and a second base plate defining a second planar surface area. The two-post rack can define a lateral axis and a depth axis, the lateral axis extending through both of the pair of vertical posts, and the depth axis being transverse the lateral axis. The first base plate can be positioned at a first side of the pair of vertical posts, and the second base plate can be positioned at a second side of the pair of vertical posts, opposite the first side in a depth direction parallel to the depth axis. The first planar surface area can be greater than the second planar surface area. The cooling unit can include a fan and a liquid-to-air heat exchanger. The cooling unit can be mounted to the two-post rack on the first side, above the first base plate.

In some examples, the two-post rack includes an opening at least partially defined by the pair of vertical posts the opening defining a first area parallel to a reference plane transverse to the depth axis, the cooling unit defines an air-flow path having a second area parallel to the reference plane, and the first area is larger than the second area. In some examples, the standalone cooling assembly further includes a gasket secured to the two-post frame at the second side of the two-post frame. In some examples, the cooling unit includes: a controller; and at least two power supply units. In some examples, the controller, and the at least two power supply units are accessible from an external portion of the cooling unit, and are each configured for toolless installation and removal, wherein removal of one of the controller, and one of the at least two power supply units does not interrupt a cooling operation of the standalone cooling assembly. In some examples, the fan comprises an axial fan.

Some examples of the disclosure provide a cooling system for cooling electrical equipment within a data center including a standalone cooling assembly. The standalone cooling assembly can include a cooling unit and a two-post rack. The cooling unit can define an air flow path having a first cross-sectional area. The cooling unit can have at least one fan assembly, the fan assembly configured to induce a flow of air through the air flow path. The two-post rack can include a vertical post, at least partially defining an opening having a cross-sectional area that is greater than or equal to the first cross-sectional area. A base plate can be configured to contact a floor of the data center, the base plate including an opening sized and positioned to allow hosing to enter the standalone cooling assembly. A planar flange can extend from the vertical post in a first direction, the planar flange at least partially defining a mounting cavity, the mounting cavity sized and configured to receive the cooling unit, and the cooling assembly mounted within the mounting cavity.

Features which are described in the context of separate aspects and/or embodiments of the invention may be used together and/or be interchangeable wherever possible. Similarly, where features are, for brevity, described in the context of a single embodiment, those features may also be provided separately or in any suitable sub- combination. Features described in connection with the standalone cooling assembly or other elements/components described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the invention and, together with the description, serve to explain the principles of embodiments of the invention:
FIG. 1 is a schematic of a rear-door cooling unit, according to an embodiment of the invention;
FIG. 2 is a front, right isometric view of a rear-door cooling unit, according to an embodiment of the invention;
FIG. 3 is a front, right isometric view of a rear-door cooling unit, according to an embodiment of the invention;
FIG. 4 is a front, right isometric view of a rear-door cooling unit mounted onto an enclosure frame, according to some embodiments;
FIG. 5 is a right elevation view of the rear-door cooling unit of FIG. 3;
FIG. 6 is a front elevation view of the rear-door cooling unit of FIG. 3;
FIG. 7 is a top plan view of a row of three rear-door cooling units;

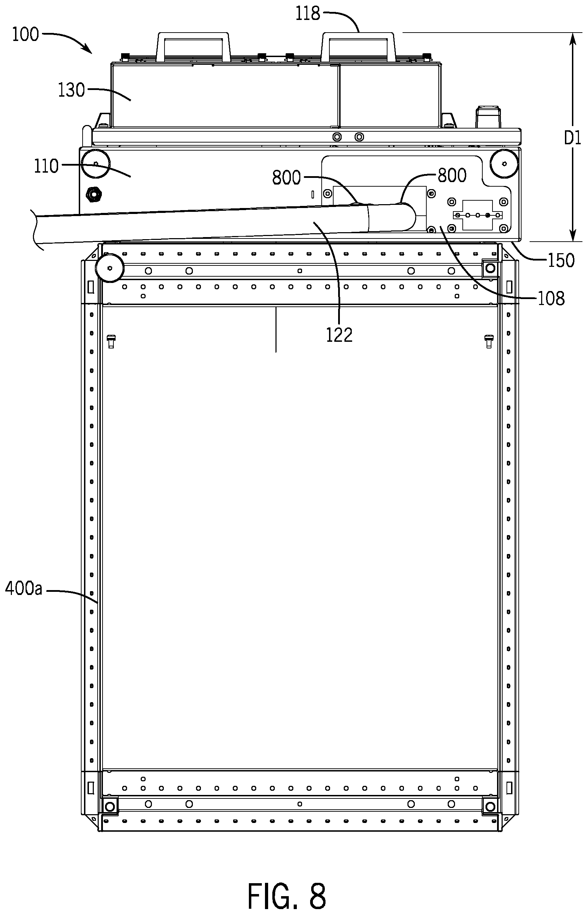

FIG. 8 is a bottom plan view of the rear-door cooling unit of FIG. 3;
FIG. 9 is a partial bottom view of the rear-door cooling unit of FIG. 3;

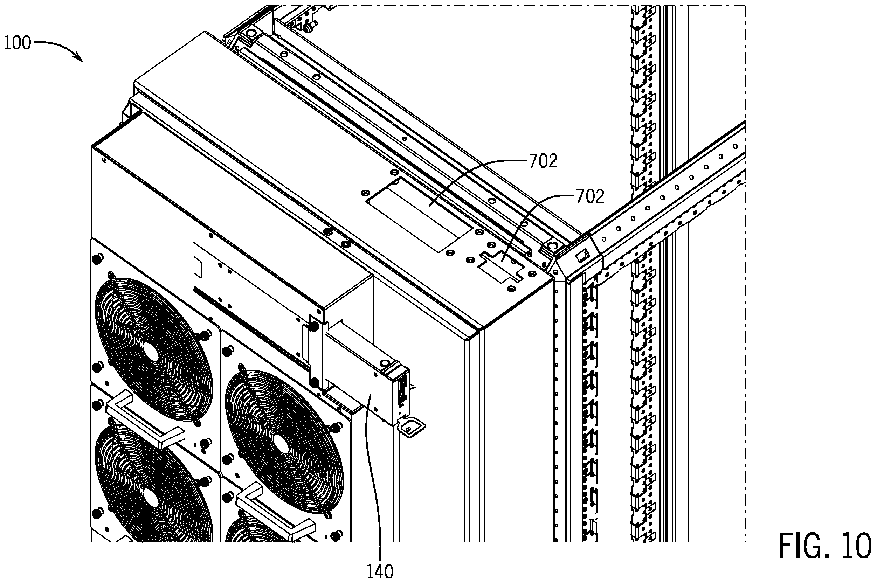

FIG. 10 is a partial top view of the rear-door cooling unit of FIG. 3;
FIG. 11 is an isometric view of a hot-swappable controller usable with the rear-door cooling unit of FIG. 3;
FIG. 12 is a rear isometric view of the rear-door cooling unit of FIG. 3, showing a heat exchanger of the rear-door cooling unit;
FIG. 13 is a partial bottom view of the rear-door cooling unit of FIG. 3 showing flexible hosing in a bottom of the rear-door cooling unit;
FIG. 14 is a partial bottom view of the rear-door cooling unit of FIG. 3 with the flexible hosing removed to show power inlet for the power supply units;
FIG. 15 is a system schematic showing a controller, fan module, and sensing components of a rear-door cooling unit;
FIG. 16 is a front right isometric view of a standalone cooling assembly including a rear-door cooling unit and a two-post rack, according to some aspects of the disclosure;
FIG. 17 is a rear right isometric view of the standalone cooling assembly of FIG. 16;
FIG. 18 is a top plan view of the standalone cooling assembly of FIG. 16;
FIG. 19 is a front right isometric view of a two-post rack for use in a standalone cooling assembly, according to some aspects of the disclosure;
FIG. 20 is a right elevation view of the two-post rack of FIG. 18;
FIG. 21 is a top plan view of the two-post rack of FIG. 18;
FIG. 22 is a front left isometric view of a row of two-post racks installed in a data center;
FIG. 23 is a front left isometric view of a row of standalone cooling assemblies installed in a data center, each standalone cooling assembly being positioned adjacent to a corresponding rack of electrical equipment to provide cooling for the corresponding rack;
FIG. 24 is a partial front view of the front of the two-post rack, according to some embodiments; and
FIG. 25 is a partial rear view of the liquid to air cooling unit mounted to the two-post rack of FIG. 24.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In some implementations, devices or systems disclosed herein can be utilized, manufactured, installed, etc. using methods embodying aspects of the invention. Correspondingly, any description herein of particular features, capabilities, or intended purposes of a device or system is generally intended to include disclosure of a method of using such devices for the intended purposes, of a method of otherwise implementing such capabilities, of a method of manufacturing relevant components of such a device or system (or the device or system as a whole), and of a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the invention, of the utilized features and implemented capabilities of such device or system.

In some embodiments, aspects of the invention, including computerized implementations of methods according to the invention, can be implemented as a system, method, apparatus, or article of manufacture using standard programming or engineering techniques to produce software, firmware, hardware, or any combination thereof to control a processor device (e.g., a serial or parallel general purpose or specialized processor chip, a single- or multi-core chip, a microprocessor, a field programmable gate array, any variety of combinations of a control unit, arithmetic logic unit, and processor register, and so on), a computer (e.g., a processor device operatively coupled to a memory), or another electronically operated controller to implement aspects detailed herein. Accordingly, for example, embodiments of the invention can be implemented as a set of instructions, tangibly embodied on a non-transitory computer-readable media, such that a processor device can implement the instructions based upon reading the instructions from the computer-readable media. Some embodiments of the invention can include (or utilize) a control device such as an automation device, a special purpose or general-purpose computer including various computer hardware, software, firmware, and so on, consistent with the discussion below. As specific examples, a control device can include a processor, a microcontroller, a field-programmable gate array, a programmable logic controller, logic gates etc., and other typical components that are known in the art for implementation of appropriate functionality (e.g., memory, communication systems, power sources, user interfaces and other inputs, etc.). In some embodiments, a control device can include a centralized hub controller that receives, processes and (re)transmits control signals and other data to and from other distributed control devices (e.g., an engine controller, an implement controller, a drive controller, etc.), including as part of a hub-and-spoke architecture or otherwise.

The term "article of manufacture" as used herein is intended to encompass a computer program accessible from any computer-readable device, carrier (e.g., non-transitory signals), or media (e.g., non-transitory media). For example, computer-readable media can include but are not limited to magnetic storage devices (e.g., hard disk, floppy disk, magnetic strips, and so on), optical disks (e.g., compact disk (CD), digital versatile disk (DVD), and so on), smart cards, and flash memory devices (e.g., card, stick, and so on). Additionally, it should be appreciated that a carrier wave can be employed to carry computer-readable electronic data such as those used in transmitting and receiving electronic mail or in accessing a network such as the Internet or a local area network (LAN). Those skilled in the art will recognize that many modifications may be made to these configurations without departing from the scope or spirit of the claimed subject matter.

Certain operations of methods according to the invention, or of systems executing those methods, may be represented schematically in the FIGS. or otherwise discussed herein. Unless otherwise specified or limited, representation in the FIGS. of particular operations in particular spatial order may not necessarily require those operations to be executed in a particular sequence corresponding to the particular spatial order. Correspondingly, certain operations represented in the FIGS., or otherwise disclosed herein, can be executed in different orders than are expressly illustrated or described, as appropriate for particular embodiments of the invention. Further, in some embodiments, certain operations can be executed in parallel, including by dedicated parallel processing devices, or separate computing devices configured to interoperate as part of a large system.

As used herein in the context of computer implementation, unless otherwise specified or limited, the terms "component," "system," "module," "block," and the like are intended to encompass part or all of computer-related systems that include hardware, software, a combination of hardware and software, or software in execution. For example, a component may be, but is not limited to being, a processor device, a process being executed (or executable) by a processor device, an object, an executable, a thread of execution, a computer program, or a computer. By way of illustration, both an application running on a computer and the computer can be a component. One or more components (or system, module, and so on) may reside within a process or thread of execution, may be localized on one computer, may be distributed between two or more computers or other processor devices, or may be included within another component (or system, module, and so on).

Also as used herein, unless otherwise limited or defined, the terms "about," "substantially," and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. In contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some cases, a lateral direction can be a radial or other perpendicular direction relative to a reference direction.

The following discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected embodiments and are not intended to limit the scope of embodiments of the invention. Skilled artisans will recognize the examples provided herein have many useful alternatives and fall within the scope of embodiments of the invention.

Cooling systems can be provided for data centers to cool electrical components within a data center. During operation, electrical components, typically housed in racks having a standard rack footprint (e.g., a standard height, width, and depth), generate heat. As that heat may degrade electrical components, damage the systems, or degrade performance of the components, cooling systems can be provided for data centers for transferring heat away from racks of the data center with electrical components that need to be cooled.

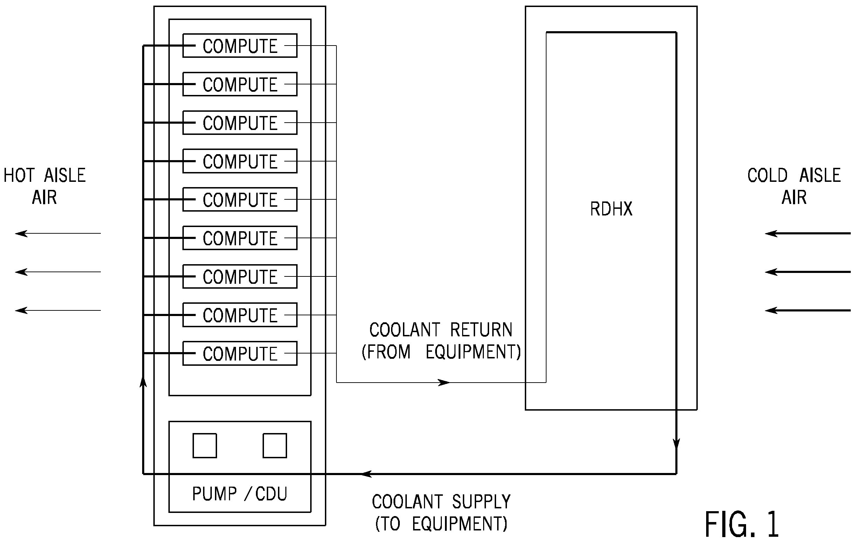

Cabinets or racks containing electrical equipment are typically arranged in rows within a data center, defining aisles between consecutive rows. Racks can be pre-assembled and "rolled in" to a space in the row adjacent to other racks, the space being pre-defined to have the footprint of a standard rack which can have widths of 600mm, 750mm, 800mm etc. This arrangement allows a modular construction of or addition to components in a data center. In some configurations, aisles on opposite sides of a rock of cabinets can be alternately designated as a cold aisle, or a hot aisle, and heat generated by the electrical components of a cabinet can be expelled to the hot air aisle, as shown in FIG. 1.

FIG. 1 illustrates a schematic for a rear-door cooling unit, according to some embodiments of the invention. Heat from a cabinet housing electrical equipment can be transferred away from the electrical equipment into the hot aisle. In the illustrated embodiment, a rack of electrical equipment is shown on the left, and a rear-door cooling unit is shown in the right. The cabinet can be positioned between a hot aisle and a cold aisle. In some cases, a rear of the cabinet can face to the cold aisle, and the front of the cabinet can face the hot aisle. In another example the rear of the cabinet can face the hot aisle, and the front of the cabinet can face the cold aisle. The rear-door cooling unit can be mounted on a rear of the cabinet.

As illustrated, the system can be a liquid-to-air cooling system, with a coolant loop distributing coolant to the cabinet containing electrical equipment. The coolant can be water, for example, and a pumping unit (e.g., a coolant distribution unit or CDU) can be provided to induce a flow through the coolant loop. As coolant flows through the system, it is heated by the heat generated by the electrical components, and the flow of the heated fluid away from the electrical components thus transfers that heat away from the components.

The heated coolant fluid can then flow into the rear-door cooling unit and can flow through a liquid-to-air heat exchanger in the rear-door cooling unit, which can transfer heat from the coolant to the surrounding air, thus cooling the fluid within the coolant loop. The cooled coolant fluid may then return through the coolant loop to cool the electrical components. In some embodiments, fans may be provided to generate an air-flow across the heat exchanger, increase a cooling efficiency of the system. In some embodiments, the fans can further enhance a cooling of the system by directing the air toward a hot aisle, for example. In the illustrated embodiment, the rear-door cooling unit is facing the cold aisle and blows air of the cold aisle across the liquid-to-air heat exchanger and across the electrical equipment toward the hot aisle. In some cases, the rear-door cooling unit can face the hot aisle and can draw air across the electrical equipment and across the heat exchanger and can blow the air out toward the hot aisle. In the illustrated example, the rear-door cooling unit is a liquid-to-air cooling unit. In other examples, a rear-door cooling unit can be an air-to-liquid cooling unit or a liquid-to-liquid cooling unit

In some cases, cooling systems (e.g., rear-door cooling units, coolant distribution units, heat exchangers, pumping units, etc.) can impact an uptime of electrical equipment within a data center. For example, a failure in a cooling system can require that electrical equipment cooled by the cooling system be shut down until cooling can be restored, to prevent overheating of the electrical equipment. It can be advantageous to provide cooling systems (e.g., rear-door cooling units) that can be resilient to component failures, so that failure of a component of the cooling system does not produce a failure of the cooling system and consequent downtime or degrading of the cooled electrical equipment. In some cases, some components of a cooling system can be redundant, and upon removing the component, the cooling system can fail over to a backup component. For example, according to some embodiments, as discussed below, power supply units of a rear-door cooling unit can be redundant, and a rear-door cooling unit can be provided with two or more power supply units. The power supply units can be configured to operate in parallel (e.g., two or more power supply units can operate at the same time), in primary-backup configurations, or in other power supply arrangements. Upon failure or removal of one power supply unit, then, the remaining one or more power supply units can operate to provide power to the electrical components of the rear-door cooling unit. In some cases, other components of a rear-door cooling unit can be redundant, or otherwise resilient to failure of a single component, including fans, control units, filtration systems, fluid flow paths, etc.

According to some embodiments, cooling systems for cooling electrical equipment within a data center can also include features and systems for toolless removal and installation of components, to increase an ease of maintenance of the system. For example, electrical components of a rear-door cooling unit, including fans, power supply units, controllers, pumps, condensate pumps, leak detection systems, sensing components (e.g., fluid flow sensors, temperature sensors, pressure sensors, humidity sensors, etc.) can include blind mate connections that correspond to blind mate connections of the rear-door cooling unit to provide electrical connectivity and communication without the need for manual connection of electrical components. In some cases, fasteners for securing components (e.g., fans) to the rear-door cooling unit can be engages without tools for installation and removal of fans. For example, thumb screws can be used to secure fans (e.g., fan assemblies) to the rear-door cooling unit. In some cases, fluid flow components can also include systems for toolless maintenance. For example, liquid connections can use quick-connect fittings.

In some cases, opening a rear-door cooling unit can produce an interruption in cooling of electrical equipment. Some conventional rear-door cooling units can require opening the rear door to access the components to be maintained. Some embodiments of the rear-door cooling can provide advantages over conventional cooling systems by providing access to components to be maintained from an exterior of the unit, without requiring interruption to cooling of the electrical equipment to access the components.

In some embodiments, rear-door cooling units, including the rear-door cooling units described below can produce an air flow of up to about 12 meters cubed per hour (m³/h). In some embodiments, a rear-door cooling unit can consume 1500 watts (W). In some cases, a rear-door cooling unit can provide 85 kW of cooling power at a 14 degrees Celsius water supply and a 24 degrees Celsius air supply. In some cases, a rear-door cooling unit can provide 48 kW of cooling power at a 20 degrees Celsius water supply and a 24 degrees Celsius air supply. In some cases, a rear-door cooling unit can provide 39 kW of cooling power at a 24 degrees Celsius water supply and a 27 degrees Celsius air supply. In some cases, a rear door cooling unit can be sized to be mounted onto a rack with a height of 42 rack units (U). In some cases, a rear door cooling unit can be sized to be mounted onto a rack with a height of 47 rack units (U).

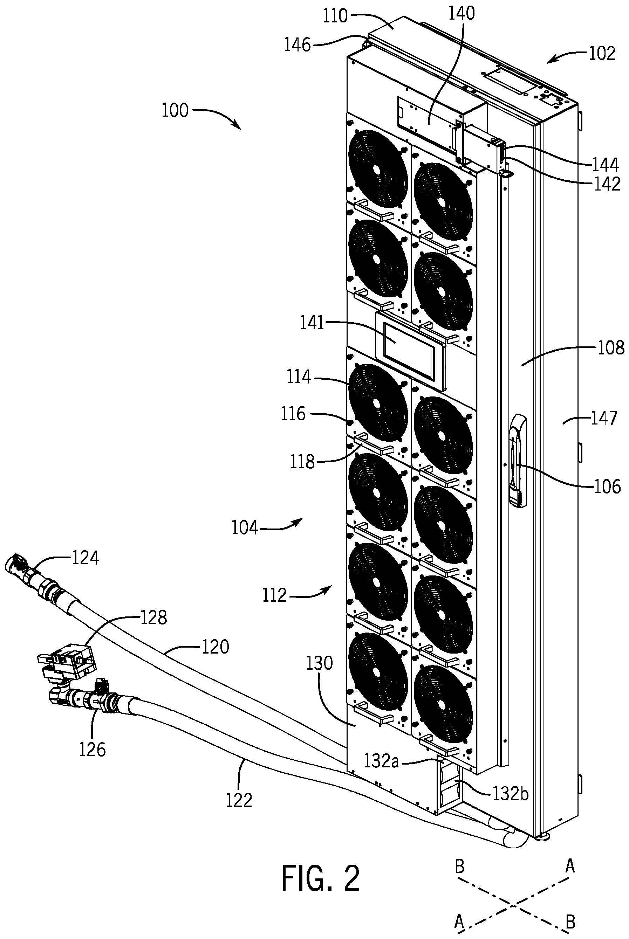

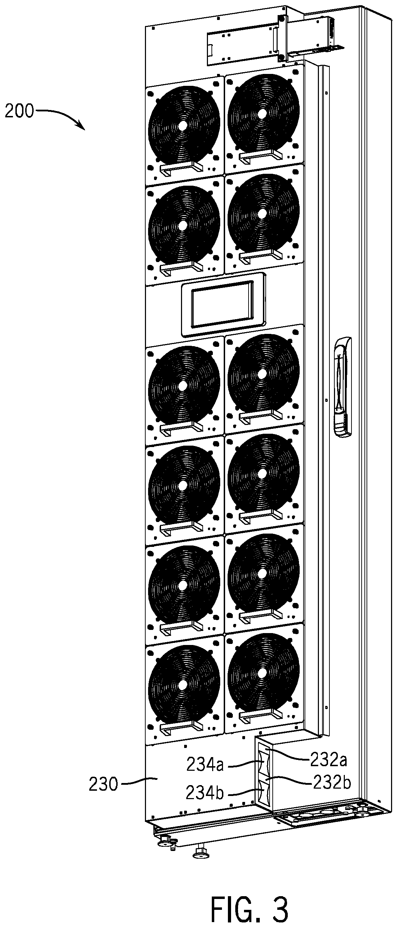

FIG. 2 illustrates an example of a rear-door cooling unit 100, according to some aspects of the present disclosure. The rear-door cooling unit can define an internal portion 102 configured to be proximate to a rack of electrical equipment when the rear-door cooling unit 100 is mounted to the rack (e.g., as shown in FIG. 3). An external portion 104 can be opposite the internal portion 102 (e.g., in a direction further from the rack to which the rear-door cooling unit 100 is mounted than the internal portion 102) and can face an aisle within a data center (e.g., a cold aisle or a hot aisle, as shown in FIG. 1). The external portion 104 can be accessible from an aisle of the data center, and an operator of the rear-door cooling unit 100 can access components of the rear-door cooling unit 100 positioned along the external portion 104 for maintenance without opening the rear-door cooling unit 100. In some embodiments, as illustrated, a handle 106 can be provided on a first lateral side 108 of the rear-door cooling unit 100, and a hinge side 110 of the rear-door cooling unit 100 can be laterally opposite the first lateral side 108. An operator can engage the handle 106 to open the rear-door cooling unit 100 (e.g., produce an angular rotation about an axis positioned along the hinge side 110) and provide access to the internal side 102 and equipment within the rack to which the rear-door cooling unit 100 is mounted.

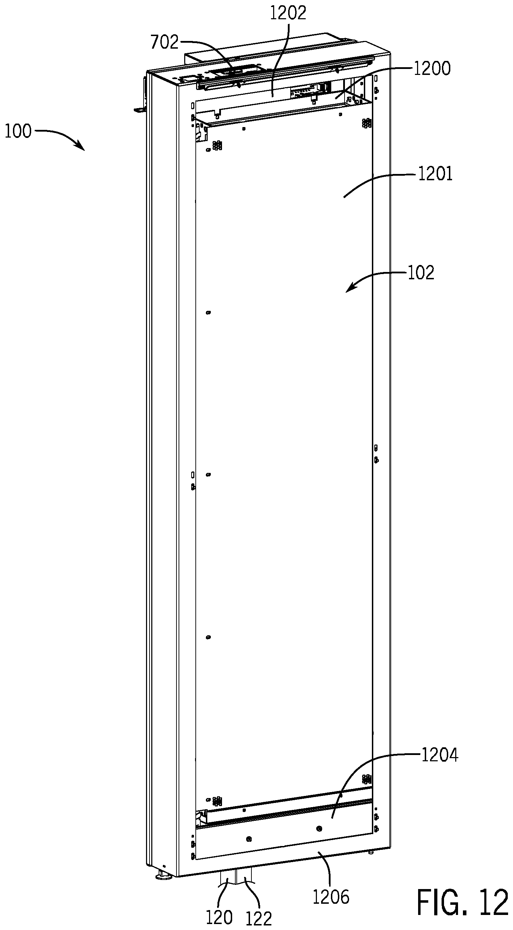

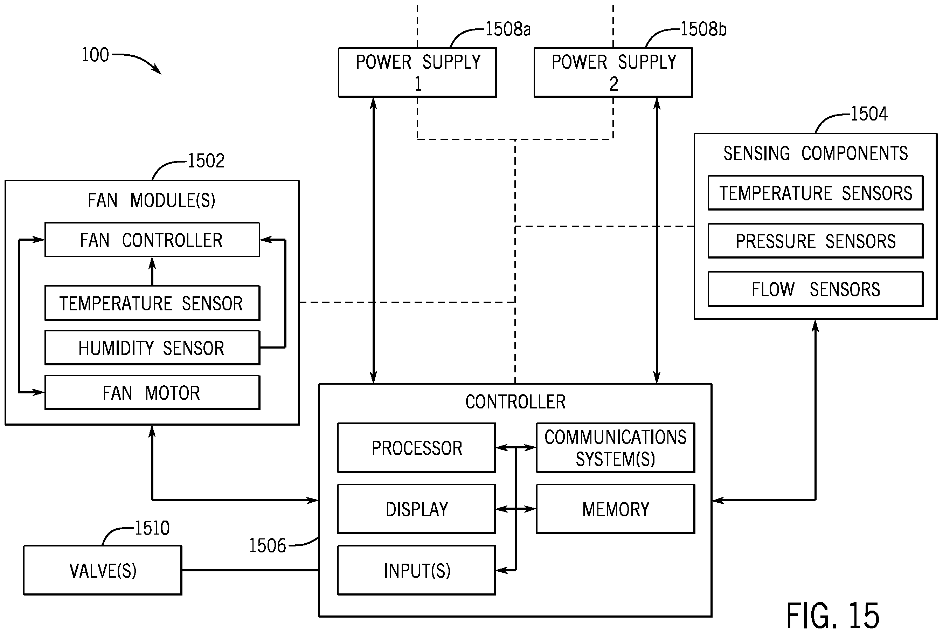

As further shown n FIG. 2, the rear-door cooling unit 100 can include a fan bank 112 with a plurality of fan assemblies 114 to induce air flow across a liquid-to-air heat exchanger (e.g., heat exchanger 1200 shown in FIG. 12) to cool electrical equipment in a rack. In the illustrated embodiment, the fan assemblies 114 are arranged in two columns and six rows, and the fan bank 112 includes 12 fan assemblies 114. In other embodiments, more or fewer columns of fan assemblies can be provided for a rear-door cooling unit including one column, three columns, four columns, etc. In some cases, a fan bank 112 can include more or fewer rows of fan assemblies, which can correlate to a height of a rear-door cooling unit. In some cases, a fan bank can include fan panels, each panel being separately maintainable (e.g., removable or installable) and can each include a plurality of fans. In some cases, as discussed further with respect to FIG. 15, the fan assemblies 114 can include fan motors, one or more sensors, and a fan controller, and can be controllable to produce a set amount of air flow across the liquid-to-air heat exchanger for a desired heat transfer rate. In some cases, the fan assemblies can include fans with a DC operating voltage of 48 V.

As illustrated, the fan assemblies 114 can be accessible from an aisle of a data center, and can be serviced (e.g., removed, installed, etc.) without a need to open the rear-door cooling unit or otherwise remove a casing, housing, etc. Fan assemblies 114 can be removed, replaced, or installed without the need to interrupt an operation of the rear-door cooling unit 100 (e.g., by opening the rear-door cooling unit) or electrical equipment cooled by the rear-door cooling unit. In some examples, when a fan assembly 114 is removed, the other fan assemblies continue operation to produce an air-flow across the liquid-to-air heat exchanger. In some cases, when one or more fan assemblies 114 are removed from the rear-door-cooling unit 100, the remaining fan assemblies 114 can increase a speed of the fans of the fan assemblies 114 to maintain a set air flow rate. Fan assemblies of a rear-door cooling unit can include features to allow a toolless removal and installation of the fan assemblies. For example, as illustrated, the fan assemblies 114 can be secured to the rear-door cooling unit 100 with the use of thumb screws 116, which can be manually tightened or loosened (e.g., removed) by an operator without the need for tools. Additionally, fan assemblies 114 can each include one or more handles 118 which can provide a gripping location for an operator to engage the fan assembly 114 to pull the fan assembly 114 from the rear-door cooling unit 100 and to grip the fan assembly 114. The fan assemblies 114 can include blind mate connections (not shown) in a rear portion thereof, which can engage (e.g., contact, or matingly engage)

A rear-door cooling unit can include piping components to fluidly connect the rear-door cooling unit (e.g., a liquid-to-air heat exchanger of the rear-door cooling unit) with a fluid cooling circuit for a rack of electrical equipment. For example, a rear-door cooling unit can include hosing and piping for a return line to allow heated fluid to flow into a liquid-to-air heat exchanger of the rear-door cooling unit, and a hosing and piping of a supply line to provide cooled liquid from the rear-door cooling unit to the electrical equipment to be cooled (e.g., as illustrated in FIG. 1). In this regard, FIG. 2 further illustrates return line hosing 120 for heated fluid to enter the rear-door cooling unit 100 and supply line hosing 122 for cooled fluid to exit the rear-door cooling unit 100 to the electrical equipment to be cooled. In the illustrated embodiment, the return line hosing 120 and the supply line hosing 122 are shown in a bottom feed configuration (e.g., entering the rear-door cooling unit 100 at a bottom thereof). In some examples, hosing can enter the rear-door cooling unit 100 in a top-feed configuration (e.g., at a top of the unit 100). The hosing 120, 122 can include quick-connect fittings 124, 126 respectively, to allow a toolless and substantially leak-free connection and disconnection to fluid circuits of electrical equipment to be cooled (e.g., to manifolds, other hosing, in-row cooling circuits, pumping units, filtration systems, etc.). In some cases, sensors can be provided along one or both of supply line 122 and return line hosing 120 to measure parameters (e.g., temperature, pressure, flow rate, etc.) of the fluid in the supply or return line hosing 122, 120. In some cases, valves can be provided along a fluid flow path for fluid of a rear-door cooling unit (e.g., rear-door cooling unit) to allow, control, or halt fluid flow through the unit. As shown the supply line of the rear-door cooling unit 100 includes a valve 128 that is electronically controlled. The valve 128 can be selectively controlled to achieve a desired flow rate of fluid, to stop the flow of fluid, or to allow all fluid flow through the rear-door cooling unit 100.

Rear-door cooling units can include power supply units for providing power to electronic components of the unit. For example, the electronic components of a rear-door cooling unit can require 48 V DC while a power provided from a facility can be provided as AC voltage. In some cases, power supply units of a rear-door cooling unit can transform an AC voltage (e.g., a single phase or multi-phase AC voltage) from a facility to a DC voltage to power the electrical components of the rear-door cooling unit. As illustrated in FIG. 2, the rear-door cooling unit 100 can include a power supply housing 130 arranged at a bottom of the unit 100. The housing 130 can house one or more power supply units 132. In the illustrated embodiment, the rear-door cooling unit 100 include two power supply units 132a, 132b within the housing, the power supply unit 132a positioned vertically above the power supply unit 132b. In other embodiments, a rear-door cooling unit can include only one power supply unit, or more than two power supply units. The power supply units 132a, 132b are each configured to receive an AC voltage and output a 48V DC signal. In some case, power supply units can be configured to transform an AC voltage to produce a signal with any desired voltage and current. In some cases, a power supply housing can be positioned at a top of a rear-door cooling unit, or centrally to a rear-door cooling unit.

The power supply units 132a, 132b can be redundant power supply units, and the rear-door cooling unit 100 can operate with at least one of the power supply units 132a, 132b in operation. If one of the power supply units 132a, 132b fails, the other of the power supply units 132a, 132b can provide power to all of the electrical components of the rear-door cooling unit. In some cases, the power supply units 132a, 132b can be operated in active-active mode with both operating in parallel to provide power to the rear-door cooling unit 100. In some cases, the power supply units 132a, 132b can be operated in active-passive mode with only one of the power supply units 132a, 132b in operation at a given instance of time. In some cases, a control system of the rear-door cooling unit 100 can alternate the active power supply periodically to equalize a wear on the power supply units 132a, 132b. In some cases, the power supply units can be operated in active-standby mode, with a first of the power supply units 132a, 132b being a primary power supply unit and a second of the power supply units 132a, 132b being a secondary power supply unit. In active-standby mode, the primary power supply unit can be the default operational power supply unit, and the secondary power supply unit can be inactive until the primary power supply unit is not in operation (e.g., upon failure or removal of the primary power supply unit).

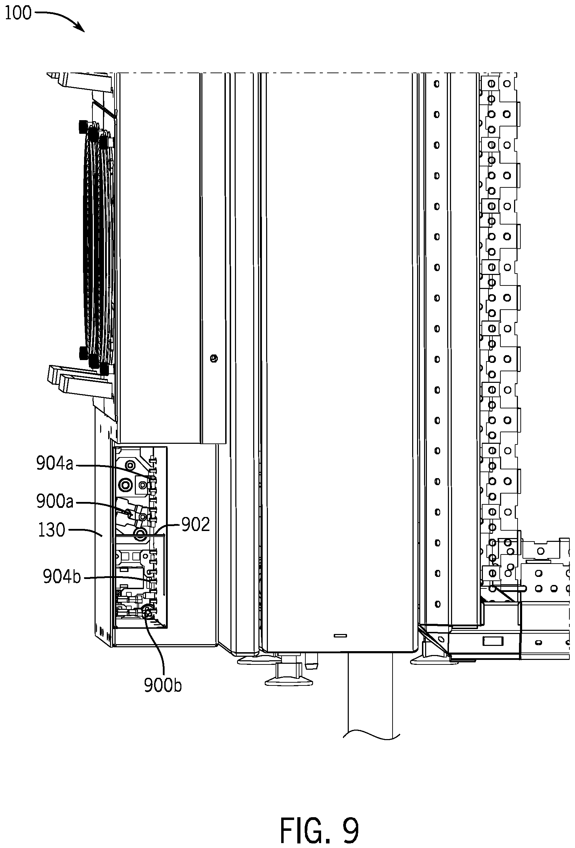

As shown in FIG. 2, the power supply units 132a, 132b can be positioned along the external portion of the rear-door cooling unit 100 and can be accessible to an operator from an aisle of the data center without opening the rear-door cooling unit (e.g., without interrupting an operation of the rear-door cooling unit 100). The power supply units 132a, 132b can include blind mate connections (not shown) to interface with electrical and mechanical connections of the rear-door cooling unit 100 (e.g., as illustrated in FIG. 9). In some cases, the power supply units can be inserted and removed from the housing 130 in a lateral direction that is parallel to axis B. As discussed further below, this arrangement can advantageously reduce a clearance required (e.g., a total depth required for installation and maintenance of the rear-door cooling unit 100 in a depth direction parallel to axis A) for the rear-door cooling unit 100. In some embodiments, power supply units of rear-door cooling units can include handles to allow an operator to grip the power supply unit to pull the power supply unit out of the housing. In this regard, FIG. 3 illustrates a rear-door cooling unit 200 with a housing 230 including two power supply units 232a, 232b, which can be similar to power supply units 132a, 132b. As shown in FIG. 3, the power supply units 232a, 232b can include handles 234a, 234b to provide a contact and gripping location to engage the respective power supply unit 232a, 232b.

Returning to FIG. 2, a controller 140 can be provided for the rear-door cooling unit 100 to implement control systems and methods for the rear-door cooling unit 100. For example, the controller can be configured to control one or more fan speed of the fans in the fan assemblies 114 to achieve a desired heat transfer rate. In some cases, the controller can implement proportional integral derivative (PID) controllers to adjust one or both of fan speed and a flow rate of fluid through the liquid-to-air heat exchanger to achieve a set point for one or more target parameters (e.g., air or fluid temperature, air or fluid temperature differentials, pressure drop, air flow rate, etc.). The controller 140 can be hot-swappable and can be removed from the rear-door cooling unit 100 without causing an interruption in cooling of the electrical equipment. As shown, the controller 140 is accessible from the external side of the rear-door cooling unit 100, and removal, installation, and replacement of the controller 140 can be performed without opening the rear-door cooling unit. In some cases, if the controller fails or is removed from operation, electronic components (e.g., fans, flow control components, etc.) can operate at default speeds (e.g., the last known speed, or a hardcoded default speed) until the controller 140 is replaced or is operational. As shown, the controller can be removed or installed in a lateral direction, parallel to axis B. The controller 140 can include one or more retention mechanisms, which can be disengaged by displacing a handle 142 of the controller 140 to allow removal of the controller 140. In some embodiments, the controller 140 can define a front surface 144 that is perpendicular to the axis B. As illustrated, the rear-door cooling unit 100 can include an interface 141. The interface 141 can comprise a touchscreen display to display information to an operator. In some cases, the touchscreen display can receive an input from an operator to control operation of the rear-door cooling unit 100 (e.g., to select an operating mode, to define a desired colling rate, to power the rear-door cooling unit on or off, etc.). The interface can be in communication with the controller and can display the information received from the controller. In some cases, the interface 141 can be a 7-inch touch panel display.

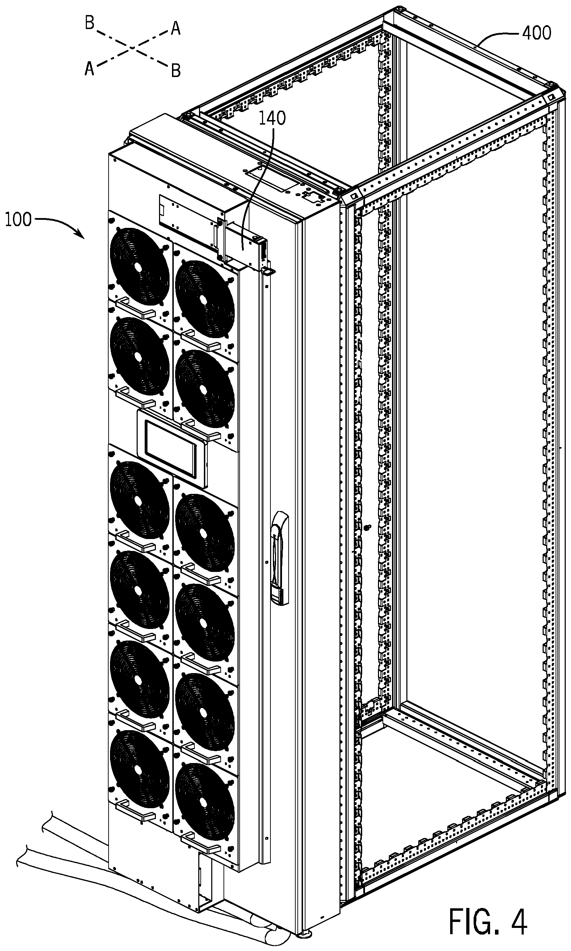

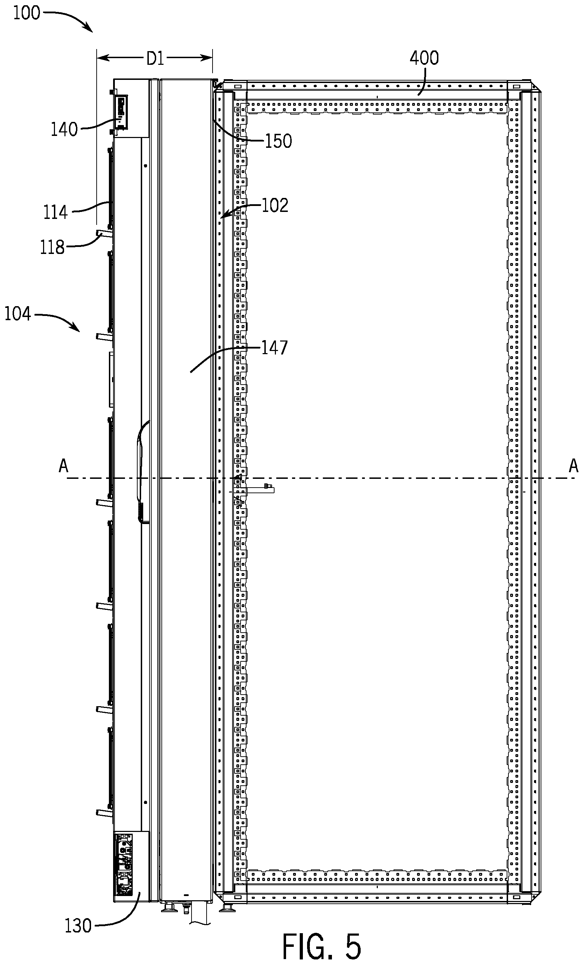

FIG. 4 illustrates the rear-door cooling unit 100 mounted on an enclosure frame 400, which can be an enclosure frame housing electrical equipment to be cooling by the rear-door cooling unit 100. As shown, the rear-door cooling unit 100 can increase a total footprint (e.g., an amount of floor space in a data center required for a rack of electrical equipment) by adding to the depth of the enclosure frame 400. In some case, it can be advantageous to minimize a total depth of a rack (e.g., an enclosure frame) and associated rear-door cooling unit, due to space constraints within a data center, to increase an aisle width, etc. Embodiments of the rear-door cooling units disclosed herein can advantageously reduce a depth required for a rear-door cooling unit, including by providing for lateral installation and maintenance of components. In this regard, FIG. 4 illustrates the controller 140 partially removed from the unit 100, and, as shown, removing the controller 140 does not require additional clearance for the rear-door cooling unit 100 in the depth direction parallel to axis A. Further, as shown, the controller 140 and power supply units 132a, 132b (e.g., as shown in FIG 2) are elongate in a parallel direction to axis B, so that a total depth of the rear-door cooling unit does not need to accommodate the elongate dimension of these components. For example, FIG. 5 is a side elevation view of the rear-door cooling unit 100 mounted to the enclosure frame 400. As shown, the rear-door cooling unit extends from the enclosure frame 400 by a depth D1 in a direction parallel to the axis A. In some cases, the depth D1 can be smaller than a total length of the controller 140 in an elongate direction of the controller 140. In some cases, the depth D1 can be less than or equal to 250 mm.

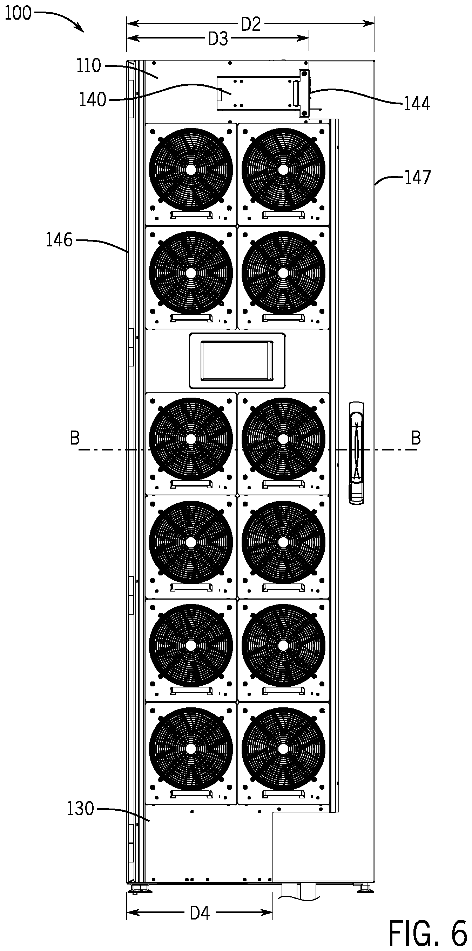

FIG. 6 is a front elevation view of the rear-door cooling unit 100. As shown, the rear-door cooling unit can have a width D2 in a direction parallel to the B axis. In the illustrated embodiment, the front face 144 of the controller 140 can extend to a width D3 from a lateral edge 146 of the rear-door cooling unit in a direction parallel to the axis B. A difference between the width D2 and the width D3 can be sufficient to remove the controller 140 in a direction along the B axis without the face 144 of the controller 140 extending past the rear-door cooling unit 100. In some cases, the difference between the width D2 and the width D3 is greater than a length of the controller 140. In some cases, the housing 130 can extend to a width D4 in a direction along the B axis from the lateral edge 146. A difference between the width D4 and the width D2 can be greater than or equal to an elongate length of one or both of the power supply units 132a, 132b. The width D4 can be sufficient to allow the power supply units 132a, 132b to be removed or installed without extending past the rear-door cooling unit 100.

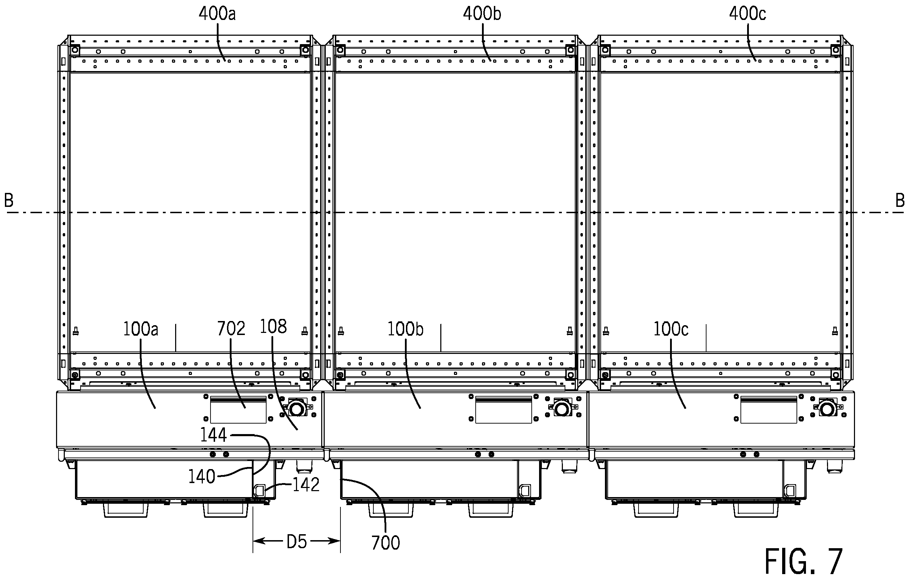

Racks can be arranged in a row within a data center. FIG. 7 illustrates enclosure frames 400a, 400b, 400c arranged consecutively in a row, with enclosure frame 400a on a first lateral side of enclosure frame 400b, and enclosure frame 400c on a second lateral side of enclosure frame 400c. Each of the enclosure frames 400a, 400b, 400c, has an associated rear-door cooling unit 100a, 100b, 100c. As shown, the rear-door cooling units 100a, 100b, 100c, are adjacent to each other. As shown, a surface 700 of the rear-door cooling unit 100b can oppose the front face 144 of the controller 140 of the rear-door cooling unit 100a and can be spaced apart from the front face 144 by a distance of D5 when the controller 140 is installed. The distance D5 can be configured to allow removal of the controller 140. For example, the distance D5 can be greater than an elongate length of the controller 140 so that the controller 140 can be removed from the rear-door cooling unit without contacting the surface 700. Similarly, the distance D4 (e.g., shown in FIG. 6) can be configured to allow the power supply units 132a, 132b to be removed without abutting an opposing surface of an adjacent rear-door cooling unit. FIG. 7 further illustrates apertures 702 in a top of the rear-door cooling units 100a, 100b, 100c to allow hosing to enter a top of the respective units 100a, 100b, 100c in a top feed configuration. In some cases, a condensate pump can be provided in the rear-door cooling unit, to prevent condensation in the unit which may damage components of the unit when the hosing is in a top feed configuration.

FIG. 9 illustrates an inside of the housing 130 of the rear-door cooling unit 100. As shown, the housing 130 can include a first bay 900a sized and configured to receive a first power supply unit (e.g., power supply unit 132a) and a second bay 900b sized and configured to receive a second power supply unit (e.g., power supply unit 132b). The bays 900a, 900b can be separated and at least partially defined by a divider 902. In some cases, a housing for power supply units can include only one bay, or more than two bays. As further shown, each bay 900a, 900b can include blind mate connections 904a, 904b respectively. The blind mate connections 904a, 904b can include power supply connections for an AC power supply input and a DC power supply output. The blind mate connections 904a, 904b can also include communication interfaces to operatively connect the power supplies to a controller (e.g., the controller 140) to control modes of operation of the power supply units, or to receive operating parameters therefrom.

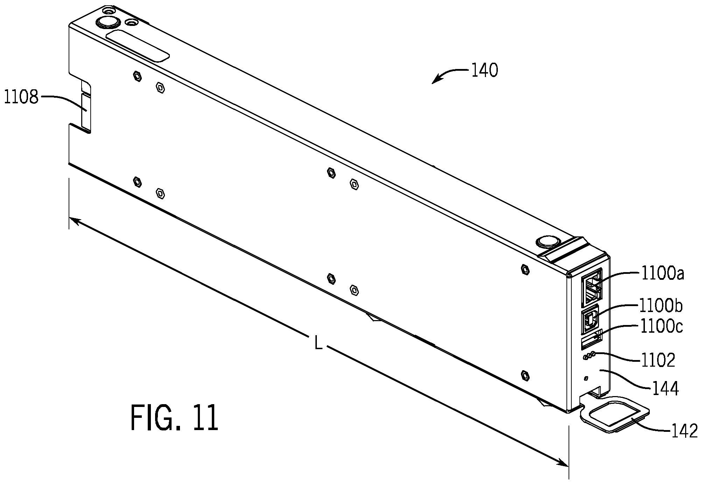

FIG. 11 is an isometric view of the controller 140, according to some embodiments. As shown, the controller can include one or more interfaces 1100a, 1100b, 1100c for wired connections to the controller 140. In some cases, the interfaces can include one or more USB interfaces, an ethernet interface, a Modbus interface, etc. The controller can include visual indicators 1102 (e.g., LEDs) for providing a visual indication of an operational state of the controller 140. Further, the controller can include blind mate connections 1108 at a back therefore to automatically connect the controller to communication systems and power supply of the rear-door cooling unit (e.g., the rear-door cooling unit 100) when the controller is installed in the rear-door cooling unit. The controller 140 can define a length L in an elongate direction of the controller 140, which can be configured to allow removal and installation of the controller 140 in a rear-door cooling unit 100 without the need to open the rear-door cooling unit 100 or otherwise interrupt a cooling operation of the rear-door cooling unit.

FIG. 12 illustrates a rear of the rear-door cooling unit, showing components along the internal portion 102 of the rear-door cooling unit 100. As shown, a liquid-to-air heat exchanger 1200 can be provided within the rear-door cooling unit 100. The liquid-to-air heat exchanger 1200 can be a high-performance heat exchanger with vertical fins and hydrophilic coating. In some cases, a heated liquid from the electrical equipment can flow into the heat exchanger 1200, and heat of the heated liquid can be transfers to an air surrounding the heat exchanger 1200. Cooled liquid from the heat exchanger 1200 can flow back to the electrical equipment to cool the electrical equipment. As shown, the rear-door cooling unit can provide a hosing compartment above the heat exchanger 1200 for housing hosing entering the rear-door cooling unit 100 in a top feed configuration (e.g., through the apertures 702). Quick- connect hydraulic fittings (not shown) can be provided in a top of the rear-door cooling unit 100 to fluidly connect hosing entering from a top feed to the heat exchanger 1200. In the illustrated embodiment, hosing enters in a bottom feed configurations, and a panel 1204 is provided to cover the hosing. Further, a condensate tray 1206 can be provided in a bottom of the rear-door cooling unit 100 to receive any condensation and leaked fluid.

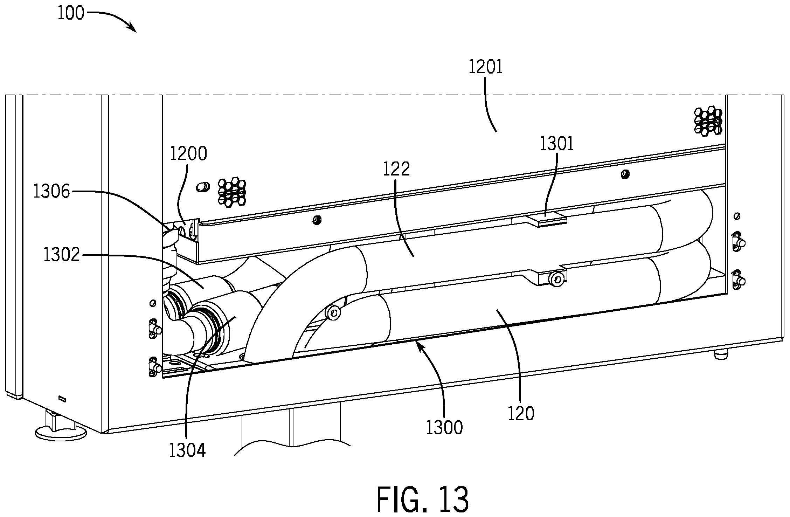

FIG. 13 illustrates a bottom of the rear-door cooling unit 100 with the panel 1204 removed to show the return line hosing 120 and the supply line hosing 122 arranged in the bottom compartment 1300 of the rear-door cooling unit 100. As shown, the bottom compartment 1300, and thus the hosing 120, 122 is beneath the heat exchanger 1200. This arrangement can be advantageous, as in the illustrated configuration, no hosing of the supply or return line hosing 120, 122 is positioned within an air flow path (e.g., along a front or rear surface of 1200 heat exchanger 1200), thus increasing a cooling efficiency of the rear-door cooling unit 100. Further, the arrangement shown can advantageously improve over some conventional systems, as swivel mechanisms are not required for the hosing 120, 122 to maintain the hosing in place, and allow for the opening and closing of the rear-door cooling unit 100 without negatively displacing the hosing 120, 122. As shown, brackets 1301 can be provided within the bottom compartment 1300 to retain the hosing 120, 122 in a desired position within the bottom compartment 1300. In other embodiments, hosing (e.g., hosing 120, 122) can enter the rear-door cooling unit 100 in a top feed configuration, and can be housed in compartment 1202 (e.g., illustrated in FIG. 12) to keep the hosing from entering an air flow path of air flow across the heat exchanger 1200. As shown, hydraulic quick-connect fittings 1302, 1304 can be provided to connect hosing 120, 122 to a fluid outlet and fluid inlet respectively of the heat exchanger 1200. The hosing 120, 122 can be installed and removed without the need for tools by connecting quick-connect fittings of the hosing 120, 122 with the hydraulic quick-connect fittings 1302, 1304.

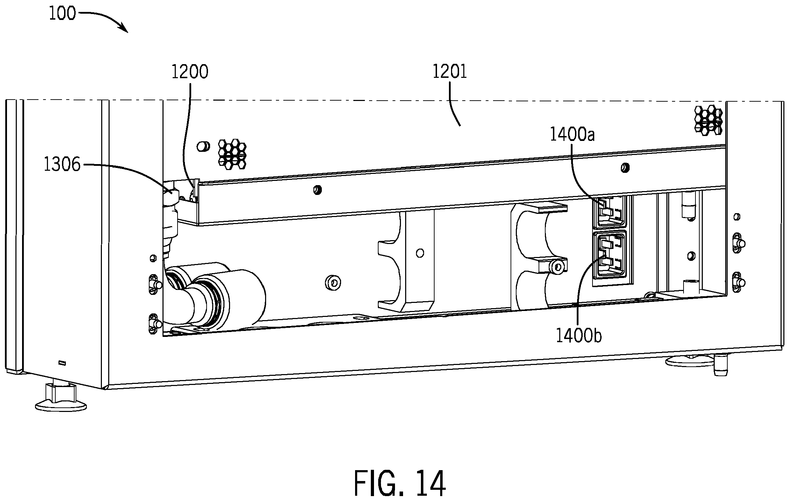

FIG. 14 illustrates a bottom of the rear-door cooling unit 100 showing the bottom compartment 1300 with the hosing 120, 122 removed. As shown, electrical connections 1400a, 1400b can be provided within the compartment 1300 to receive power from power cords of a facility. Each of the electrical connections 1400a, 1400b can provide power to a corresponding power supply unit 132 in a corresponding bay 900a, 900b of the housing 130.

FIG. 15 illustrate a control system 1500 for a rear-door cooling unit (e.g., rear-door cooling units 100, 200) described above. As shown, the control system 1500 can include one or more fan modules 1502 (e.g., one or more of the fan assemblies 114 shown in FIG. 15), sensing components 1504, and a controller 1506 (e.g., the controller 140). Any or all of the fan modules 1502, the controller 1506, and the sensing components 1504 can receive DC power from power supply units 1508a, 1508b (e.g., power supply units 132a, 132b shown in FIG. 2 and power supply units 232a, 232b shown in FIG. 3). The sensing components of the control system 1500 can include temperature sensors, pressure sensors, flow sensors, humidity sensors, differential temperature sensors, differential pressure sensors, or other know sensor types. The sensing components 1504 can sense parameters of an air, or a fluid of a rear-door cooling unit. For purposes of illustration, only one Fan Module 1502 is shown, however, it is to be understood that the control system 1500 can include any number of fan modules and associated fans, including, for example, 12 fans, as shown and described with respect to FIG. 2.

As illustrated, the fan module 1502 can include a fan controller, which can provide local controls for an individual fan module. The fan module 1502 can further include a fan motor which can include a fan speed sensor, a Humidity Sensor, and a Temperature Sensor. Each of the Fan Speed Sensor, Humidity Sensor, and Temperature Sensor can provide measurements for a sensed value to the Fan Controller. The Fan Motor, as shown, which can receive a signal from the Fan Controller to drive an operation of the Fan Motor. As further shown, the Fan Controller can be in communication with the Controller 1506. In normal operation of the control system 1500, the Controller 1506 can provide sensed values from any of the described sensors to the Control Unit (e.g., to either or both of Controller 1 and Controller 2) and can receive a signal from the Control Unit to drive operation of the Fan Motor. In other cases, including when a communication between the Fan Module and the Control Unit is interrupted, the Fan Controller can autonomously control a speed of the Fan Motor, according to instructions preprogrammed in the Fan Controller. In some examples, when a fan controller is autonomously driving a fan motor, it can operate a feedback control system based on sensor parameters obtained from sensors of the fan module.

Referring back to FIG. 15, the Controller 1506 can be in communication with the Sensor Components 1504 to receive sensed values from sensors thereof. The Controller 1506 can provide signals (e.g., instructions) to one or more of the Fan Controllers. In some embodiments, the Controller 1506 can further be in communication with one or more flow control components (e.g., valves, pumps, etc.) to implement control processes for operating the rear-door cooling unit to achieve a set value for one or more sensors of the Sensor Components 1504.

In some examples, communication between components of the control system 1500 can be over a wired connection (e.g., a Modbus, an ethernet connection, USB connections, etc.). In some embodiments, communication between one or more elements of the control system can occur via a wireless connection (e.g., a wi-fi connection, a cellular connected, etc.).

In some embodiments, the controller 1506 can be a programmable logic controller (PLC). In some embodiments, the controller 1506 can include a processor, one or more Input/Output interfaces, a Communication System(s), and a Memory. In some embodiments, the Processor can be any suitable hardware processor or combination of processors, such as a central processing unit (CPU), a graphics processing unit (GPU), an application specific integrated circuit (ASIC), a field-programmable gate array (FPGA), etc. In some embodiments, one or more Input/Output interfaces can include any suitable display device, such as a computer monitor, a touchscreen, a television, any suitable input devices and/or sensors that can be used to receive user input, such as a keyboard, a mouse, a touchscreen, a microphone, a camera, etc. Inputs can be received at a display which can present a user interface through which an operator can view system parameters, and set control parameters (e.g., set an operating mode, define set points for temperature or pressure, set a language of the system, etc.).

In some embodiments, the Communication System(s) of the controller 1506 can include any suitable hardware, firmware, and/or software for communicating information over any suitable communication networks. For example, the Communication System(s) can include one or more transceivers, one or more communication chips and/or chip sets, etc. In a more particular example, the Communications System(s) can include hardware, firmware and/or software that can be used to establish a Wi-Fi connection, a Bluetooth connection, a cellular connection, an Ethernet connection, etc. In some embodiments, inputs can be received at the controller 1506 through the Communication System(s) (e.g., over a communication network).

In some embodiments, the Memory can include any suitable storage device or devices that can be used to store instructions, values, *etc.,* that can be used, for example, by the Processor of the controller 1506 to implement control loops and algorithms, to store logs of the controller 1506, etc. The Memory can include any suitable volatile memory, non-volatile memory, storage, or any suitable combination thereof. For example, the Memory can include random access memory (RAM), read-only memory (ROM), electronically-erasable programmable read-only memory (EEPROM), one or more flash drives, one or more hard disks, one or more solid state drives, one or more optical drives, etc. In some embodiments, the Memory can have encoded thereon a computer program for controlling operation of the Controller 1506.

In some contexts, it can be desirable to facilitate a movement (e.g., an installation, removal, and replacement) of racks of electrical equipment within a data center. For example, some workloads and applications can require a large quantity of similarly (e.g., identically) configured racks of electrical equipment, and in some cases, the intensity of compute workloads or advancement of technology can require frequent servicing or replacement of components in the data center. In some cases, a cost of troubleshooting and replacing individual components in a rack of electrical equipment can be cost-prohibitive at large scales, and an operator of a data center can choose instead to remove the rack including a failed component and roll in a new rack to replace the rack with a failed component (e.g., roll in a rack with electrical equipment pre-installed and integrated according to desired specification of the data center operator). It can be advantageous to provide systems and methods to reduce a labor cost included in installing and removing a rack for servicing, as can advantageously reduce a cost of operation of a data center and provide modularity to ease a servicing of components in a data center.

In this regard, it can be useful to provide standalone cooling assemblies, which, in some cases can include rear-door cooling units (e.g., the rear-door cooling unit 100, 200 shown in FIGS. 1 and 2) for cooling racks within a data center. Standalone cooling assemblies can be installed within a data center in a fixed location in the data center, and racks of electrical equipment to be cooled can be positioned proximate to the standalone cooling assembly. When the rack is positioned proximate the standalone cooling assembly, electrical components within the rack can be cooled by cooling elements (e.g., a rear-door cooling unit) of the standalone cooling assembly. In some cases, cooling the components in the rack does not require that the rack be mechanically secured (e.g., with fasteners) to the standalone cooling assembly, and the rack can be moved (e.g., installed, removed, replaced, etc.) without requiring a corresponding movement (e.g., installation, replacement, removal) of the standalone cooling assembly. In some cases, cooling a rack of electrical equipment via a standalone cooling assembly can include fluidly coupling a liquid-to-air heat exchanger to a cooling loop within the rack to be cooled, to provide continuous cooling to a coolant liquid flowing through the rack. While the examples below describe, in particular, standalone cooling units including liquid-to-air heat exchangers (e.g., including rear-door cooling units similar or identical rear door cooling units 100, 200 shown in FIGS. 1 and 2), cooling units of a standalone cooling assembly can include air-to-liquid heat exchangers, liquid-to-liquid heat exchangers, refrigeration cycles, or a transfer of heat from the rack through introduction of cool air through the rack (e.g., cooling units including fan banks with no liquid cooling elements).

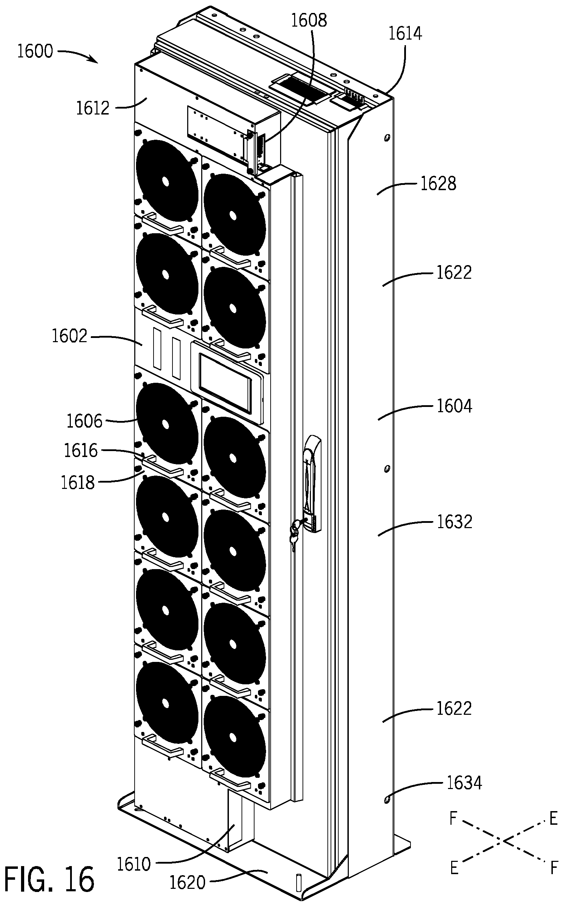

A standalone cooling assembly can include a mounting structure configured be fixed in place (e.g., fastened to a position on a floor) within a data center, and a liquid-to-air cooling unit mounted on the mounting structure. Standalone cooling assemblies, according to this disclosure can be secured to a floor along an aisle of a data center (e.g., one or both of a cool aisle and a hot aisle as illustrated in FIG. 1), with fans of the liquid-to-air cooling unit facing into the aisle, and a side of the liquid-to-air cooling unit opposite the fans facing a rack to be cooled. For example, FIG. 16 is a front right isometric view of a standalone cooling assembly 1600, according to some examples of this disclosure. As illustrated, the standalone cooling assembly 1600 includes a cooling unit 1602 and a two-post rack 1604 (e.g., a mounting structure). The liquid-to-air cooling unit 1602 can be mounted to the two-post rack 1604, and the two-post rack 1604 can provide structures and features to retain the cooling unit 1602 in place. In some cases, the cooling unit 1602 can be mounted to the two-post rack 1604 with the use of fasteners (e.g., screws, nails, rivets, bolts, threaded shafts and nut arrangements, etc.). In some cases, the cooling unit 1602 can be welded to the two-post rack 1604. The cooling unit 1602 can include a hinge as can allow all or a portion of the unit 102 to swing open along a vertical axis (e.g., an axis parallel to the direction of gravity). When the cooling unit 1602 is swung open relative to the two-post rack 1604, an operator can access a back of a rack of electrical equipment through the two-post rack 1604 without the need to disassemble the standalone cooling assembly 1600. As shown in FIG. 16, a depth direction can be defined in a direction parallel to the axis E. As used throughout, then, the term "depth" is used to mean a direction that is parallel to axis E as shown. Further, the standalone cooling assembly defines a lateral direction parallel to axis F. For example, as shown, respective vertical posts 1624 are positioned on opposite lateral sides of the assembly, spaced apart in a lateral direction parallel to axis F. A lateral axis parallel to axis F can thus extend through both of the vertical posts 1624 of the two-post rack.

As further illustrated in FIG. 16, the cooling unit 1602 can be similar or identical to rear-door cooling units 100, 200 shown and described with respect to FIGS. 1 and 2. For example, the cooling unit 1602 can include hot-swappable fan assemblies 1606, a hots-swappable control unit 1608, and hot-swappable power supply units 1610 configured for toolless removal from the cooling unit 1602. The fan assemblies 1606, control unit 1608, and the power supply units 1610 can be accessible from the first side of the cooling assembly 1602. Thus, as described above with respect to the rear-door cooling units 100, 200, the fan assemblies 1606, control unit 1608, and the power supply units 1610 can be serviced without opening the liquid-to-air cooling unit 1600, as would disadvantageously interrupt a cooling operation of the cooling unit 1602. In some cases, a cooling unit of a standalone cooling assembly (e.g., a cooling unit mounted to a two-post rack) can be an air-to-liquid cooling unit. In this example, a chilled facility water can flow through a heat exchanger and fans can blow an air across the heat exchanger in a direction toward the electrical components within a rack (e.g., the air can be cooled by a heat transfer from the chilled water before flowing over electrical components to cool the electrical components. In some cases, the heat exchanger of a cooling unit of a standalone cooling assembly can be positioned fluidly along a primary cooling unit, and a liquid coolant can be cooled at the heat exchanger through a liquid-to-air heat transfer before being recirculated to electrical equipment within a rack. In other example, a cooling unit can provide refrigerant-based cooling, liquid-to-liquid cooling, air cooling (e.g., blowing an air from a cold aisle across the electrical equipment within a rack), etc.

As noted, above, the fan assemblies 1606 can be positioned on a first side of the liquid-to-air cooling unit 1602 and can face outwardly into an aisle of a data center when the standalone cooling assembly 1600 is installed in the data center. The fan assemblies 1606 can induce an air flow in a direction parallel to axis E. For example, the fan assemblies 1606 can operate to draw air through a rack of electrical equipment, through the cooling unit 1602 and into the aisle, or can operate to draw air from the aisle through the cooling unit 1602 and blow the air into the rack. In some cases, fan assemblies of a standalone cooling assembly can be canted to provide an air-flow in a direction that is at an oblique angle relative to axis E (e.g., air flow can be partially directed in an elongate direction of an aisle to reduce a flow or air directly into a rack opposite the aisle from the standalone cooling assembly). In some examples, fan assemblies of a standalone cooling assembly can include radial fans as could egress air into the aisle in a direction parallel to an elongate direction of the aisle (e.g., parallel to axis F as shown).

Within a data center, it can be advantageous to provide aisles between rows of electrical equipment of sufficient width the permit transport of racks and other equipment through the aisles, and to provide an operator with space to service and access racks and components therein. For this and other reasons, it can be beneficial to provide systems that minimize a depth (e.g., an extension into the aisle) of cooling systems for individual racks of electrical equipment. As described above with respect to rear-door cooling units 100, 200, the control unit 1608 and the power supply units 1610 can be positioned and oriented within the cooling unit 1602 to minimize a total depth of the cooling unit 1602, with a maximum length direction of each of the control unit 1608 and power supply units 1610 being parallel to axis F (i.e., transverse to axis E). The control unit 1608 and power supply units 1610 can be removable from the cooling unit 1602 in a direction parallel to axis F, as can advantageously minimize a clearance within the aisle required for installation, removal, and servicing of control units 1608 and power supply units 1610.

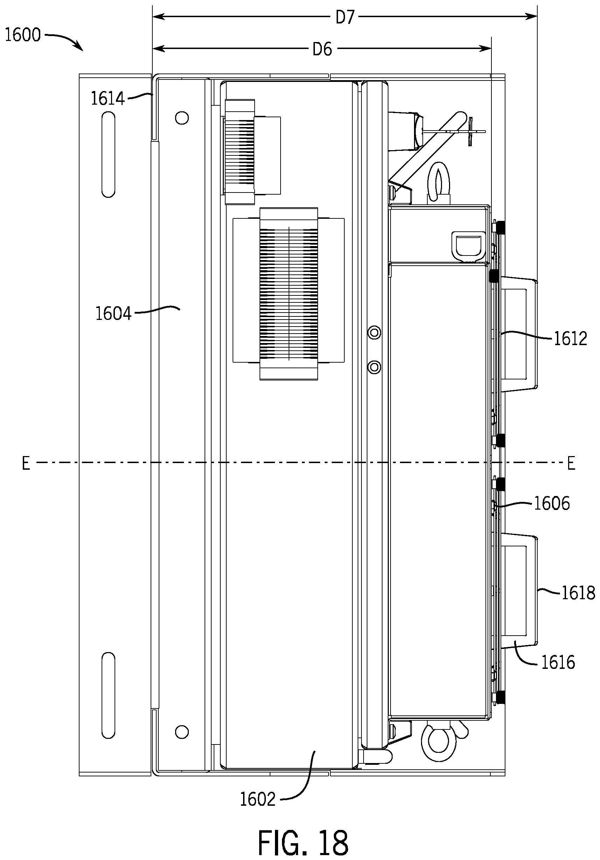

As shown, and described further below with respect to FIG. 18, the standalone cooling assembly can include an aisle-facing surface 1612 proximate the aisle (e.g., a surface of the cooling unit 1602) and a rack-facing surface 1614 proximate to the rack to be cooled and disposed opposite the aisle-facing surface 1612 in a direction parallel to axis E. In some cases, a distance between the aisle-facing surface 1612 and the rack-facing surface 1614 in a direction parallel to axis E can define a clearance of the standalone cooling assembly 1600. In some cases, a standalone cooling assembly can include fan assemblies (e.g., fan assemblies 1606) with handles to facilitate removal and installation of the fan assemblies. For example, as further shown in FIG. 16, the fan assemblies 1606 include corresponding handles 1616. The handles 1616 can extend outwardly into the aisle in a direction parallel to axis E. In some cases, a total clearance (e.g., a maximum distance, depth, or extension of the standalone cooling assembly 1600 from a back of the rack into the aisle) can be defined between a distal surface 1618 of the handle 1616 and the rack-facing surface 1614.

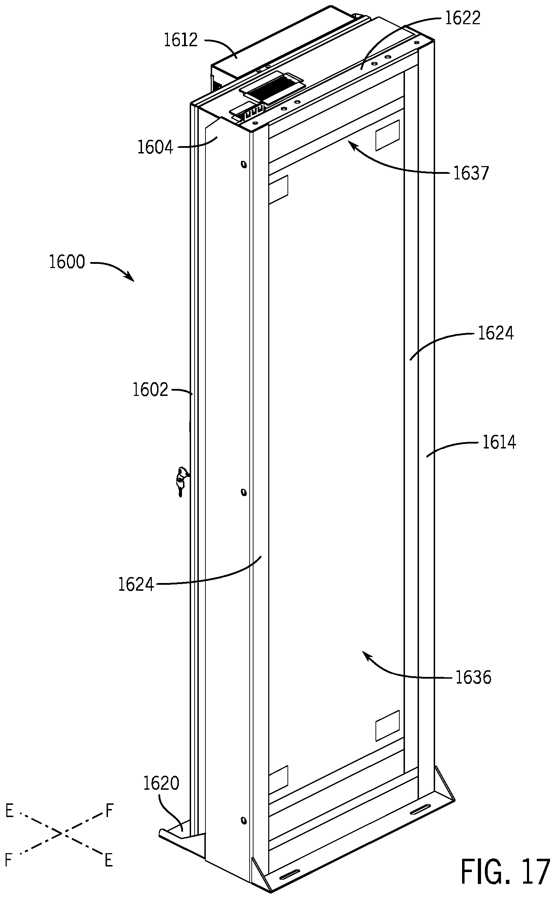

Mounting structures for standalone cooling assemblies can have features and define structures to provide stability to the standalone cooling assembly. As further illustrated in FIG. 16, the two-post rack 1604 includes a base plate 1620. The base plate 1620 defines a generally rectangular profile and provides a planar surface that interfaces with a floor of the data center when the standalone cooling assembly 1600 is installed in the data center. As illustrated in FIG. 17, a frame structure 1622 extends upwardly from the base plate 1620 (e.g., extending in a direction transverse to both the axes E and F opposite the floor of the data center). The frame structure 1622 includes vertical posts 1624 along opposite lateral sides (e.g., on opposing sides of the two-post rack 1604 in a direction parallel to the axis F) of the two-post rack 1604. In some cases, a base plate for a mounting structure of a standalone cooling assembly can be of unitary construction (e.g., can be formed from a single sheet metal piece). In some cases, a base plate for a mounting structure can be of multi-part construction with a first section (e.g., a first sheet metal piece) positioned on an aisle-facing side of posts of a two-post rack, and a second section (e.g., a second sheet metal piece) positioned on a rack-facing side of the posts.

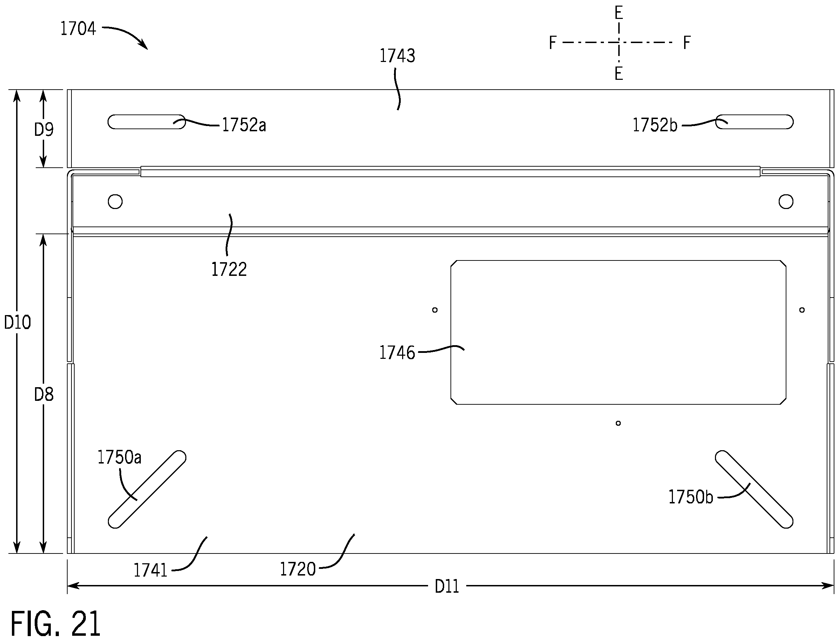

It can be useful to provide a mounting system (e.g., a base plate) for a mounting structure of a standalone cooling assembly that can stabilize the standalone cooling assembly without interfering with an installation of a rack. For example, a base plate of a cooling assembly can be sized and positioned to ensure that the base plate does not contact wheel or stabilizing features of the electronics rack when the electronics rack is installed proximate the standalone cooling assembly. Referring back to FIG. 16, and as discussed further with respect to FIG. 21, the base plate 1620 can define a first section extending outwardly from the posts 1624 in a first direction parallel to axis E (e.g., into the aisle), and can define a second section extending outwardly from the posts 1624 in a second direction that is parallel to axis E and opposite the first direction (e.g., toward the rack of electrical equipment). An area of the first section along a reference plane parallel to a plane defined by axes E and F (e.g., an area in contact with a floor) can be greater than an area of the second section defined along the reference plane. Further, a depth of the first section in the first direction (e.g., parallel to axis E and into the aisle) can be greater than a depth of the second section in the second direction (e.g., opposite the first direction). in a direction parallel to axis E can be greater than a depth of the second section in a direct

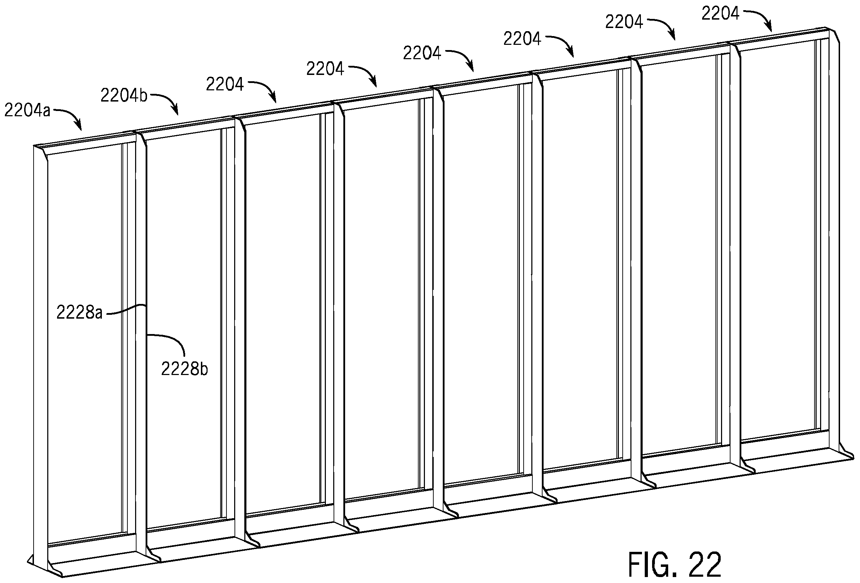

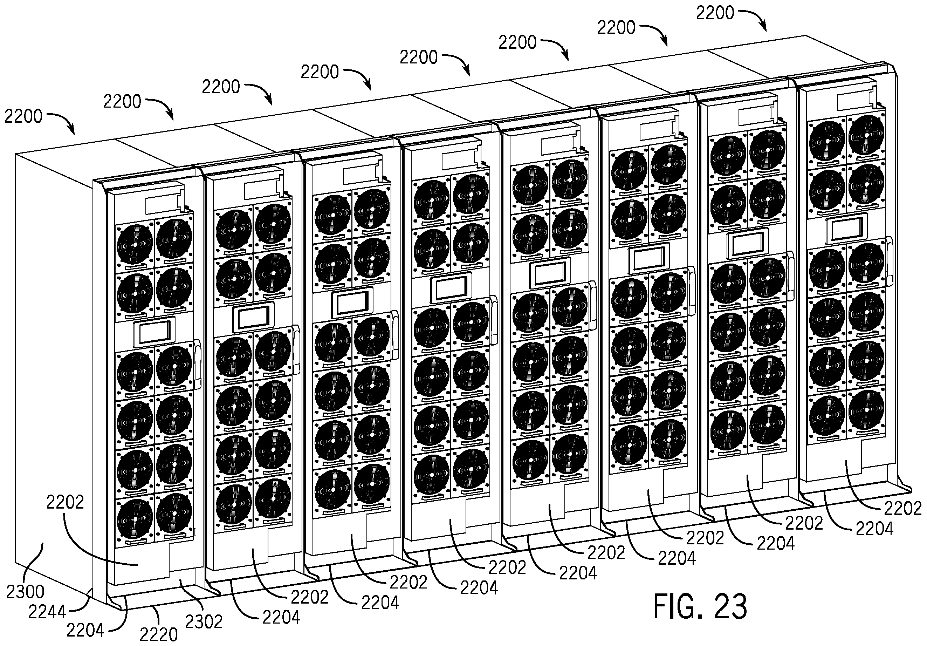

As illustrated FIG. 16, the two-post rack 1604 includes lateral flanges 1628 that extend from opposing lateral sides (e.g., from both of the posts 1624) of the frame structure 1622 toward the aisle (e.g., in a direction parallel to axis E). The lateral flanges 1628 can be substantially (e.g., completely) planar, with an inwardly facing surface in contact with the cooling unit 1602 when the liquid-to-air cooling unit is mounted to the two-post rack 1604. The lateral planar flanges 1628 can each further define an outwardly facing (e.g., facing away from the air-to-liquid cooling unit 1602 in a direction parallel to the F axis) planar surface 1632. The planar surface can be configured to permit and facilitate a serial arrangement of standalone cooling units along a row of a data center (e.g., as shown in FIGS. 22 and 23). For example, when the two-post rack 1604 is installed within a data center, the planar surface 1632 can contact a corresponding planar surface of an adjacent two-post rack. In some cases, a total width of the standalone cooling assembly can be defined as a distance between the surfaces 1632 of the lateral flanges 1628 in a direction parallel to axis F (as discussed further with respect to FIG. 21). The total width of the standalone cooling assembly can be less than or equal to a total width of an adjacent rack. For example, the standalone cooling assembly can have a total width of less than or equal to 600 mm, less than or equal to 750 mm, or less than or equal to 800 mm.

In some cases, as shown, the lateral flanges can include a plurality of apertures 1634. The apertures 1634 can be sized and positioned to facilitate securing of the two-post rack 1604 to an adjacent two-post rack (e.g., with a fastener extending through the apertures 1634 and a corresponding aperture of the adjacent two-post rack). In some cases, a flange of a two-post rack does not include apertures. In some cases, apertures of a two-post rack can be used in mounting a liquid-to-air cooling unit within the two-post rack 1604. In some cases, lateral flanges can be integral with all or a portion of a frame structure. For example, as illustrated, the lateral flanges 1628 are integrally formed with at least a portion of the lateral posts 1624 and are of integral construction with the portion defining at least a portion of the surface 1614. In some cases, a two-post rack of a standalone cooling assembly does not include lateral flanges, and a lateral width of the standalone cooling assembly can be defined by a cooling unit mounted to the two-post rack. In some cases, a two-post rack includes a lateral flange on one lateral side.

A two-post rack of a standalone cooling structure can be configured to allow a maximum air flow through a rack to be cooled. For example, as shown in FIG. 17, the frame structure can define an opening 1636. The opening 1636 can extend between the lateral posts 1624 and can be at least partially defined by the lateral posts 1624. In the illustrated example, the opening 1636 is an air-flow opening with an area that is parallel to a reference plane transverse to the depth axis E. In the illustrated example, the cooling unit 1602 defines an air flow path 1637 at least partially defined by an opening in a back of the cooling unit 1602 (e.g., a side of the cooling unit 1602 proximate the two-post rack 1604). The air flow path 1637 can allow air flow induced by the fans of the fan assemblies 1606 to enter the cooling unit 1602 (e.g., as when the fan assemblies are configured to draw air across a rack of electrical equipment) or to exit the cooling unit 1602 (e.g., as when the fan assemblies 1606 operate to blow air through the rack of electrical equipment). As illustrated, the opening 1636 and can be aligned with the air flow path 1637, and air traversing the air flow path can flow through the opening 1636. In some cases, the air flow path 1637 defines a first cross-sectional area parallel to the reference plan, and the opening defines a second cross-sectional area that is greater than or equal to the first cross sectional area. In some cases, as shown, the opening 1636 fully includes an air flow path, and no portion of the two-post rack 1604 extends into the air flow path 1637 to impede an air flow therethrough.

As noted above, the standalone cooling assemblies disclosed herein can advantageously reduce a clearance required for back-of-rack cooling systems. As illustrated in FIG. 18, the standalone cooling assembly 1600 can define a first distance D6 between the surface 1614 and the surface 1612. The distance D6 can be a clearance of the standalone cooling assembly 1600. For example, the surface 1614 can be proximate to (e.g., in contact with) a back surface of a rack of electrical equipment (e.g., in contact with a gasket positioned between the rack of electrical equipment and the standalone cooling unit), and the distance D6 can be a depth to which the standalone cooling assembly 1600 extends into the aisle from the back of the rack (e.g., a clearance that the standalone cooling assembly 1600 adds in addition to the clearance of the rack). In the illustrated example, the distance D6 is less than 320 mm. In some embodiments, including as illustrated, handles 1616 of the fan assemblies 1606 can extend further into the aisle than the surface 1612. The distal surface 1618 of the handle 1616 can define the furthest extension of the standalone cooling assembly 1600 int the aisle (e.g., in a direction parallel to axis E). A clearance of the standalone cooling assembly 1600 can be a distance D7 from the surface 1614 to the distal surface 1618 of the handle 1616. In some examples, the distance D7 can be less than 340 mm. In some cases, a maximum depth of the standalone cooling assembly (e.g., a total distance in a direction parallel to axis E between distal features or edges of the standalone cooling assembly) can be about 368 mm, or less than about 370 mm.

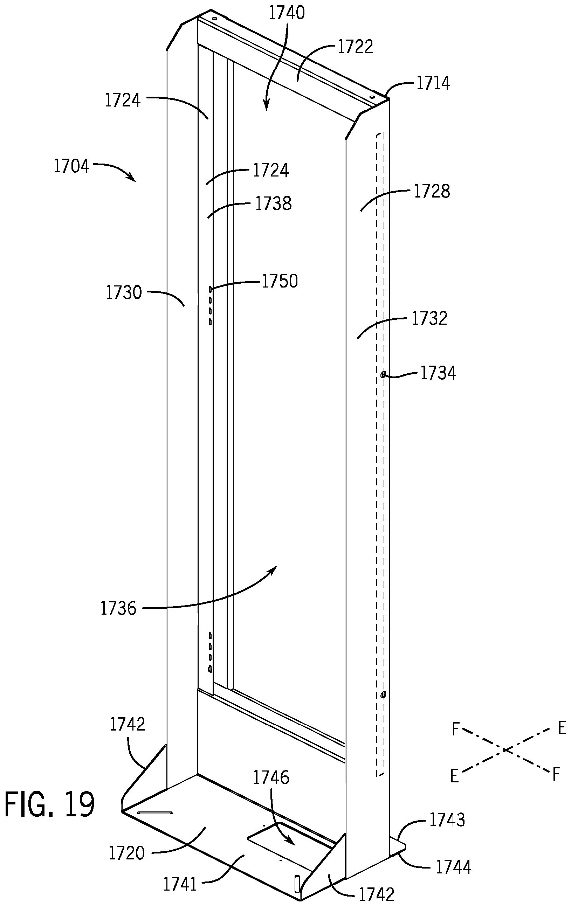

FIG. 19 illustrates a two-post rack 1704 for use in a standalone cooling assembly (e.g., standalone cooling assembly 1600 shown in FIGS. 16-18). The illustrated two-post rack 1704 can be similar or identical to the two-post rack 1604 and can include similar numbering for similar components. For example, the illustrated two-post rack 1704 includes a base plate 1720, a frame structure 1722, lateral posts 1724, and lateral flanges 1728, the lateral flanges having inwardly facing surfaces 1730 and outwardly facing planar surface 1732. The frame structure 1722 can define a forward-facing surface 1738 that faces in a direction toward the aisle. The surface 1738 and the inwardly-facing surfaces 1730 can collectively at least partially define a mounting cavity 1740 sized and configured to receive a cooling unit to be mounted to the two-post rack 1704 (e.g., the liquid-to-air cooling unit 1702 shown in FIGS. 16-18). Any or all of surfaces 1738, 1730 can include features to allow the cooling unit to be secured to the two-post rack (e.g., mounting apertures, matable features configured to engaged with corresponding features of the cooling unit, etc.). In some cases, a cooling unit can be welded to one or more of the surfaces of a two-post rack. In the illustrated example, mounting apertures 1750 are shown provided on the forward-facing surface 173 8. When mounting a cooling unit to the two-post rack 1704, apertures of a frame of the cooling unit can be aligned with the mounting apertures 1750, and fasteners (e.g., bolts or screws) can be inserted through both of the apertures of the cooling unit and the mounting apertures 1750 to secure the cooling unit to the two-post frame 1704.

A two-post rack can include structures to stabilize a frame structure of the two-post rack and oppose a bending or rotation of the frame structure in a direction towards an aisle or a rack within a data center (e.g., to oppose rotation about an axis parallel to axis F). In the illustrated example, the base plate 1720 can include a first portion 1741. As shown, ramped flanges 1742 can extend upwardly from the base plate 1720 on opposing lateral sides of the base plate 1720. The ramped flanges 1742 can extend in a direction parallel to axis E from a first side of the base plate 1720 to the planar flanges 1728. The ramped flanges 1742 can increase a structural rigidity of the two-post rack 1704. A contact of the ramped flanges 1742 with the flanges 1728 can at least partially opposed a rotational displacement of the frame structure 1722 relative to the base plate 1720. In some cases, the flanges 1742 can be integrally formed with the base plate 1720. As shown, ramped flanges 1744 can extend upwardly from the base plate 1720 along lateral sides of the base plate 1720 on a side of the frame structure 1722 opposite the ramped flanges 1742. The ramped flanges 1744 can contact the lateral posts 1724 to oppose a rotational displacement of the frame structure 1722 relative to the base plate 1720. In some cases, ramped flanges of a base plate of a two-post rack do not contact a frame structure of the two-post rack.

In some cases, two-post racks can be configured to allow hosing to enter a cooling unit mounted to the two-post rack in a top feed or bottom feed orientation. For example, as shown in FIG. 19, the base plate 1720 can define an aperture 1746 to allow entry of hosing and wiring into the standalone cooling assembly in a bottom-feed configuration (e.g., from the floor) into a cooling unit mounted onto the two-post rack (e.g., cooling unit 1602 shown in FIGS. 16-18). In the illustrated example, the aperture 1746 is rectangular with rounded corners, but in other examples, an aperture for receiving hosing and wiring can be circular, oval, square, or any other shape to allow passage of wiring and hosing therethrough. In the illustrated example, the two-post rack 1704 can allow both of a wiring and hosing to enter a standalone cooling assembly without impeding an air flow path between a cooling unit (e.g., the cooling unit 1602 shown in FIGS. 16-18) and a rack to be cooled (e.g., without hosing between the rack and the cooling unit extending through the opening 1736). In some cases, a base plate for a two-post rack can include more than one apertures for receiving wiring and hosing. In some cases, a two-post rack does not include a base plate. For example, in some embodiments a two-post rack can include stabilizing legs along opposing lateral sides of the two-post rack to oppose a rotation (e.g., a tipping) of the two-post rack) with an area between opposing lateral stabilizing legs being open, allowing for hosing and wiring to feed into a cooling unit mounted to the two-post rack at any location between the stabilizing legs.

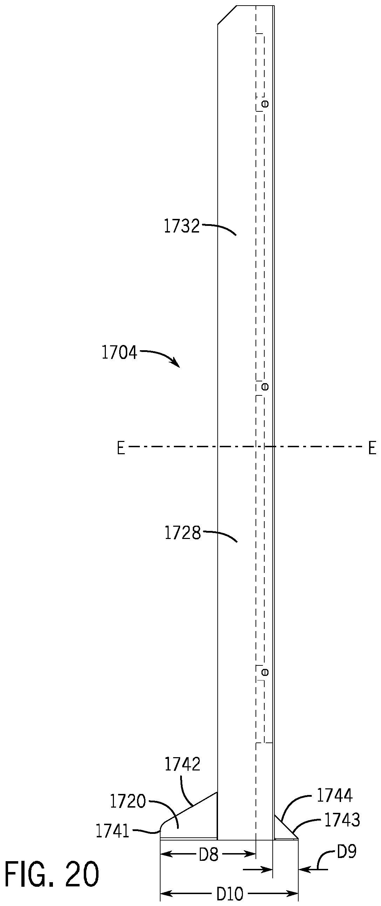

FIG. 20 is a right elevation view of the two-post rack 1704 of FIG. 19. As shown in FIG. 20, the base plate 1720 can define a total depth D10 in a direction parallel to the E axis. In the illustrated example, the depth D10 can be less than 370 mm. The base plate 1720 includes a first portion 1741 on a side of the frame structure 1722 proximate the aisle, and a second portion 1743 on an opposite side of the frame structure. The first and second portions 1741, 1743 can each be respective mounting plates. In some examples, a two-post rack includes only one mounting plate on one side (e.g., an aisle facing side or a rack-facing side) of a frame structure. In some examples, the first portion 1741 and the second portion 1743 are distinct sheet metal pieces. In other examples, the first portion 1741 and the second portion 1743 are of unitary construction. The first portion can extend from the frame structure 1722 towards the aisle in a direction parallel to the E axis, and the second portion can extend from the frame structure 1722 in a direction opposite the aisle and parallel to the E axis. In some cases, a planar area of the first portion 1741 in contact with a floor of a data center can be greater than a planar surface area of the second portion 1743 in contact with the floor. The first portion can extend a distance D8 from the frame structure, and the second portion can extend a distance D9 from the frame structure. As shown the distance D8 can be greater than D9. For example, it can be useful to provide a greater length of a base structure on a side proximate the aisle, as the two-post structure 1704 is subject to a moment when a cooling unit (e.g., the cooling unit 1602) is mounted thereto (e.g., a moment in a counter-clockwise direction as viewed from the perspective of FIG. 20). The first portion 1741 (e.g., and the ramped flange 1742) can oppose the moment produced by the weight of a cooling unit, thereby providing stability to the frame structure 1722. In an example, the distance D8 is less than 260 mm and the distance D9 is less than 70 mm. In some cases, the two-post rack 1704 can define a total width D11, as further illustrated in FIG. 21. In some cases, the total width of a two-post rack for a standalone cooling assembly can be less than about 620 mm or less than about 610 mm. In the illustrated embodiment, the width D11 is less than 600 mm, as can allow the standalone cooling assembly to be installed atop a single 600 mm by 600 mm tile within a data center.

A base plate of a two-post rack can further include features to allow the mounting of the two-post structure to a floor of a data center, as can beneficially improve a stability of the two-post structure, and limit (e.g., prevent) displacement of a standalone cooling assembly relative to a rack to be cooled by the standalone cooling assembly. In this regard, FIG. 21 illustrates mounting slots 1750a, 1750b defined in the first portion 1741 of the base plate 1720, and mounting slots 1752a, 1752b defined in the second portion 1743 of the base plate 1720. The mounting slot 1750a can be positioned on a first lateral side of the first portion 1741, and the mounting slot 1750b can be positioned on a second lateral side of the first portion 1741, opposite the first lateral side. Similarly, the mounting slot 1752a can be positioned on a first lateral side of the second portion 1743, and the mounting slot 1752b can be positioned on a second lateral side of the second portion 1743, opposite the first lateral side. As shown, an elongate direction of the mounting slots 1752a, 1752b is substantially parallel to axis F. Further, the mounting slots 1750a, 1750b are oriented with an elongate direction at an oblique angle relative to axis F. In some cases, a base plate can include mounting apertures defining other shapes (e.g., circular). In some cases, particular data centers can have specific mounting configurations, and base plates can be provided with mounting apertures or slots sized and positioned to adhere to the configurations of the particular data center.

Standalone cooling assemblies can be arranged in a row to provide cooling for respective slots in a data center. For example, standalone cooling assemblies can be arranged side-by-side along a length of a row, and racks of electrical equipment can be installed proximate a respective standalone cooling assembly in a slot of a row within the data center. This arrangement can advantageously improve the modularity of a data center, as it reduces (e.g., eliminates) the need for installation of specific cooling equipment for a given rack, and allows for locational flexibility in installing racks (e.g., removes the constraint on where particular racks can be installed based on the particular cooling requirements of the rack). For example, FIG. 22 illustrates a row of two-post racks 2204 (e.g., eight two-post racks 2204) installed along a row within a data center. Each of the two-post racks 2204 can be similar or identical to two-post rack 1604 shown in FIG. 16-18 and two-post rack 1704 shown in FIGS. 19-21 and can include similar numbering for similar component. In particular, FIG. 22 illustrates two-post rack 2204a adjacent to two-post rack 2204b. As shown, a lateral flange 2228a of two-post rack 2204a contacts a lateral flange 2228b of the adjacent two-post rack 2204b. In some cases, adjacent two-post racks can be fixed to each other (e.g., with fasteners, adhesives, through welding, etc.). While in the illustrated example, the row of two-post racks 2204 includes eight two-post racks, any number of two-post racks can be ganged along a row, including less than eight, or more than eight two-post racks.

FIG. 23 illustrates a row of standalone cooling assemblies 2200 including liquid-to-air cooling units 2202 each mounted to a respective one of the two-post racks 2204. FIG. 23 further illustrates racks of electrical equipment 2300 installed proximate each of the respective standalone cooling assemblies 2200. As shown, the racks can be received between the ramped flanges 2244 and can extend over a second portion 2243 of a base plate 2220 of the respective standalone cooling assembly. In some cases, a single mounting structure can be provided for multiple slots within a datacenter.

As further shown in FIG. 23, the liquid-to-air cooling units 2202 can include adjustable feet 2302. The adjustable feet 2302 can extend downwardly from the liquid-to-air cooling unit and can engage a surface of the base plate 2220. The adjustable feet can be extended or retracted to extend the distance between the liquid-to-air cooling unit 2202 and the base plate 2220 and can decrease a force on mounting elements (e.g., fasteners or welds) at which the liquid-to-air cooling units are mounted to the respective two-post rack 2204.

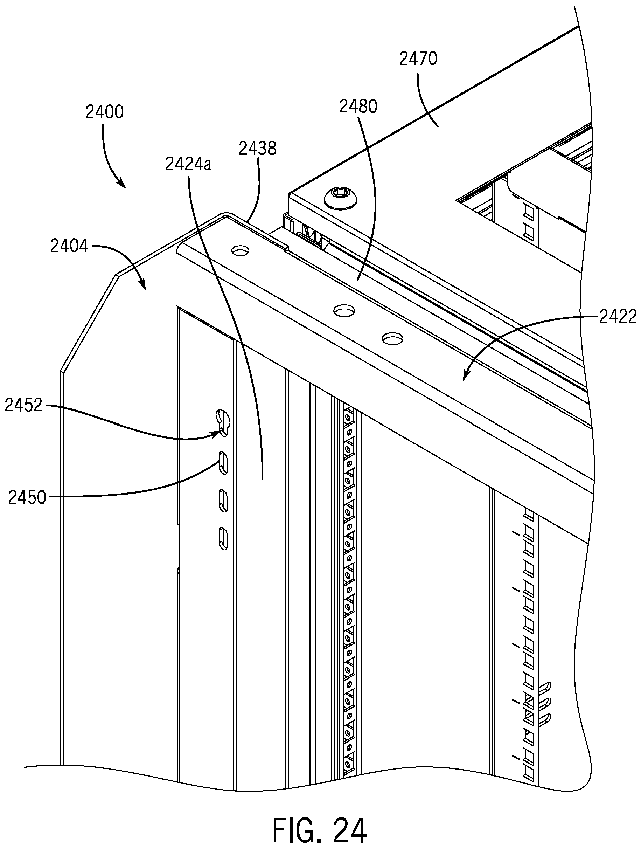

It can be advantageous to seal an interface between a standalone cooling assembly and a rack of electrical equipment against the escape of air flow, as can increase a cooling efficiency of the standalone cooling assembly. For example, a sealing member (e.g., a gasket) can be provided between a surface of a two-post rack of a standalone cooling unit and a rack of electrical equipment to block a flow of air at an interface between the surface and the rack. For example, FIG. 24 illustrates a partial view of a system including a rack of electrical equipment 2470 (e.g., similar or identical to racks 2300 shown in FIG. 23), and a two-post frame 2404 of a standalone cooling assembly 1700 (e.g., similar or identical to any of two-post frames 1604, 1704, 2204, shown in FIGS. 16, 17, and 22 respectively). As illustrated in FIG. 24, the two post rack 2404 may include a gasket or sealing member 2480 proximate to the rack to seal an interface with the rack to be cooled. In the illustrated example, the gasket 2480 contacts a surface 2438 of the two-post rack 2404 and a surface of the rack of electrical equipment 2470. The gasket can extend upwardly along the lateral posts and laterally (e.g., in a direction parallel to axis F shown in FIG. 16) along a width of the interface to seal the interface at each of the lateral sides, the top, and the bottom of the interface. In some embodiments, the gasket can be comprised of polyurethane foam or could be an edge seal. In some examples, a gasket can be formed from a rubber, or other compressible materials. In some examples, the gasket can be partially compressed when the rack of electrical equipment is positioned proximate to the standalone cooling assembly. In some cases, clamps can be provided to secure the rack of electrical equipment relative to the standalone cooling assembly and can exert a force pulling the two-post rack in a direction toward the rack of electrical equipment, and compressing the gasket.

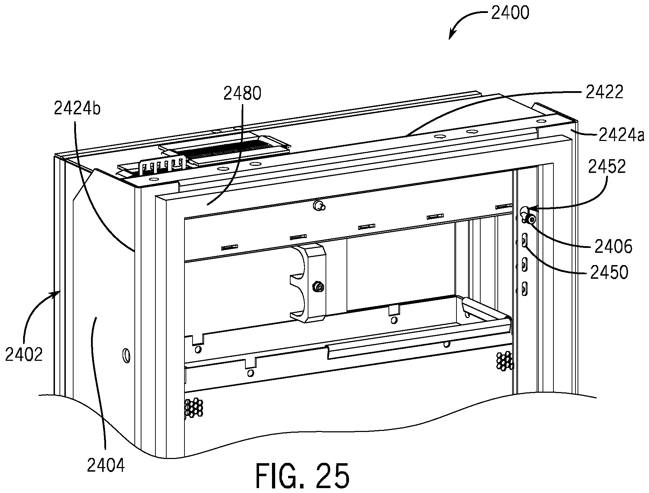

As further shown, standalone cooling assemblies can include features to aid in a mounting of a cooling unit to the two-post rack. For example, as shown, an aisle-facing surface of a lateral post 2424a of the two-post rack 2404 can define mounting apertures 2450 (e.g., similar or identical to mounting apertures 1750 shown in FIG. 19). The mounting apertures 2450 can correspond with apertures of a frame of a cooling unit and can be aligned with the apertures of the frame of the cooling unit when the cooling unit is mounted onto the two-post rack 2404 (e.g., with screws or bolts received through the respective apertures). As further shown, a keyhole aperture 2452 (e.g., an aperture with a slotted portion and a circular portion, the slotted portion defining a slot width and the circular portion defining a first diameter, the first diameter being larger than the slot width) can be provided on the post 2424a. While only one keyhole aperture is shown, it is to be understood that the lateral side of the two-post rack 2404 that is not shown (e.g., the lateral post 2424b shown in FIG. 25) is identical to the lateral side shown, including corresponding mounting apertures 2450 and keyhole aperture 2452. The keyhole slot can be oriented with the circular portion at a vertical top, and the slot portion extending downwardly from the circular portion (e.g., in the direction of gravity). The keyhole aperture 2452 can be configured to receive a corresponding protruding feature (e.g., a button, a screw, a bolt, etc.) of the cooling unit. For example, a frame of a cooling unit can include a protruding screw, and an operator can position the frame to align the protruding screw with the keyhole aperture 2452. A screw head of the protruding screw can be received through the circular portion of the keyhole aperture 2452 to toollessly position and at least partially retain the frame relative to the two-post frame 2404. When the screw head of the cooling unit is received through the circular portion of the keyhole aperture 2452, the frame (e.g., and the protruding screw) can be displaced downwardly with a shaft of the protruding screw received into the slotted portion of the keyhole aperture 2452 and a head of the protruding screw preventing a displacement of the frame of the cooling unit in a depth direction (e.g., parallel to axis E shown in FIG. 16). Thus, the illustrated system can simplify a mounting process that may otherwise require multiple workers to install by providing a mechanism by which a single worker can position a frame of a cooling unit and hang the frame on the two-post frame prior to full installation.

In this regard FIG. 25 shows a partial rear view of a cooling unit 2402 (e.g., similar to the cooling unit 1602 shown in FIG. 16) mounted onto the two-post rack 2404 according to some embodiments. As shown, a protrusion 2406 (e.g., a protruding screw, a button, a bolt, etc.) can extend from a frame of the cooling unit 2402 in a direction towards the two-post rack 2404 (e.g., a direction toward a rack of electrical equipment and parallel to axis E shown in FIG. 16). The protrusion 2406 can include a distal head (e.g., a circular screw head, a head of a button, etc.) and a shaft, the diameter of the head being greater than a diameter of the shaft. The protrusion 2406 can be pre-installed on the cooling unit 2402 (e.g., prior to mounting the cooling unit 2402 onto the two-post rack 2404). While the illustrated example only shows a protrusion 2406 received into a single keyhole aperture 2452 on the first lateral post 2424a, it is to be understood that another protrusion extends through a corresponding keyhole slot defined in the lateral post 2424b. In the illustrated example, the protrusion 2406 is shown in a "seated" position, with the shaft resting in the slotted portion of the keyhole aperture 2452. When the frame of the cooling unit 2402 is thus seated, an operator can secure the frame of the cooling unit 2042 to the two-post frame 2404, for example, by providing fasteners to extend through the mounting apertures 2450 and corresponding apertures of the frame of the cooling unit 2402. In some cases, the protrusion 2406 can be a screw that can be tightened when the frame is hung onto the two-post frame 2404 to further secure the cooling unit 2402 relative to the two-post rack 2404. Hanging the frame onto the two-post frame 2404 can include positioning the frame such that the head of the protrusion 2406 is axially aligned with the circular portion of the keyhole aperture 2452, inserting the head through the circular portion, and translating the frame to seat the shaft of the protrusion 2406 within the slotted portion of the keyhole aperture 2452.

The previous description of the disclosed embodiments is provided to enable any person skilled in the art to make or use the invention. Various modifications to these embodiments will be readily apparent to those skilled in the art, and the generic principles defined herein may be applied to other embodiments without departing from the spirit or scope of the invention. Thus, the invention is not intended to be limited to the embodiments shown herein but is to be accorded the widest scope consistent with the principles and novel features disclosed herein.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom. Features of the standalone cooling assembly or other elements/components described may be incorporated into/used in corresponding methods and vice versa.

## Claims

1. A standalone cooling assembly comprising:
a two-post rack including a pair of vertical posts and a planar base, the pair of vertical posts spaced apart in a lateral direction and at least partially defining an air-flow opening between them, and the planar base including a plurality of mounting slots each of the plurality of mounting slots configured to receive a fastener to mount the two-post rack to a floor;
a cooling unit including a heat exchanger and at least one fan assembly, the cooling unit mounted to the two-post rack, and the fan assembly configured to induce a flow of air in a depth direction across the heat exchanger and through the air-flow opening, wherein the depth direction is transverse to the lateral direction.

2. The standalone cooling assembly of claim 1, wherein a maximum width of the assembly in the lateral direction is less than or equal to 600 mm.

3. The standalone cooling assembly of claim 1, wherein a maximum depth of the assembly in the depth direction is less than 370 mm.

4. The standalone cooling assembly of claim 1, claim 2 or claim 3, wherein the planar base includes a first planar section and a second planar section, wherein the first planar section is positioned at a first side of the pair of vertical posts, and the second planar section is positioned on a second side of the pair of vertical posts, the second side opposite the first side in the depth direction.

5. The standalone cooling assembly of claim 4, wherein the first planar section defines a first length in the depth direction, and the second planar section defines a second length in the depth direction, the first length being greater than the second length.

6. The standalone cooling assembly of claim 5, wherein the standalone cooling assembly is fixed to a floor of a data center, wherein a rack of electrical equipment is positioned at the second side of the pair of vertical posts.

7. The standalone cooling assembly of claim 1 or of any of claims 2 to 6, wherein the at least one fan assembly includes an axial fan.

8. The standalone cooling assembly of claim 1 or of any of claims 2 to 7, further including a gasket installed at a periphery of the air-flow opening, the gasket configured to at least partially seal an interface between the standalone cooling assembly and a rack of electrical equipment.

9. The standalone cooling assembly of claim 1 or of any of claims 2 to 8, wherein each of the pair of vertical posts includes a mounting surface, the mounting surface defining a plane that is transverse to the depth direction, wherein a plurality of mounting apertures are defined in the mounting surface.

10. The standalone cooling assembly of claim 9, wherein the plurality of mounting apertures includes a keyhole aperture defining a circular portion and a slot portion, wherein a diameter of the circular portion is greater than a width of the slot portion.

11. A method of cooling electrical equipment within a data center, the method including:
providing a two-post rack including a pair of vertical posts and a planar base, the pair of vertical posts spaced apart in a lateral direction and at least partially defining an air-flow opening between them, and the planar base including a plurality of mounting slots;
mounting the two-post rack to a floor of a data center, wherein mounting the two-post rack includes inserting at least one fastener into one of the plurality of mounting slots;
providing a cooling unit including a heat exchanger and a fan assembly;
mounting the cooling unit onto the two-post rack, wherein, when the cooling unit is mounted on the two-post rack, the fan assembly is positioned to induce a flow of air along a depth direction transverse the lateral direction across the heat exchanger and through the air-flow opening.

12. The method of claim 11, wherein the cooling unit further includes downwardly-extending adjustable feet, wherein the method further includes extending the downwardly-extending adjustable feet until the feet contact a surface of the planar base.

13. The method of claim 11 or claim 12, wherein the planar base includes an aperture sized to receive a hosing, wherein the method further includes inserting hosing upwardly through the aperture and fluidly connecting the hosing to the heat exchanger.

14. The method of claim 11, claim 12 or claim 13, further including installing a gasket on a surface of the two-post rack, along a periphery of the air-flow opening.

15. The method of claim 11 or of any of claims 12 to 14, wherein the two-post rack includes a mounting surface defining a keyhole aperture, the keyhole aperture including a circular portion having a first diameter and a slotted portion having a first width, wherein the first diameter is greater than the first width, wherein the cooling unit includes a frame with a protrusion having a shaft and a distal head, wherein mounting the cooling unit includes:
positioning the frame with the protrusion axially aligned with the circular portion;
inserting the head of the protrusion through the circular portion; and
translating the frame so that the shaft is received into the slotted portion.
